# EUROPEAN PATENT APPLICATION

(11) **EP 4 642 014 A1**
(43) Date of publication of application: **29.10.2025**
(21) Application number: 23927181.0
(22) Date of filing: 05.12.2023
(51) Int. Cl.: H04M 1/02, G06F 1/16

(54) **ROTATING SHAFT MECHANISM AND FOLDABLE ELECTRONIC DEVICE**

(30) Priority: 13.03.2023 CN 202310290599
(71) Applicant: Honor Device Co., Ltd., Shenzhen, Guangdong 518040 (CN)
(72) Inventor: GONG, Zhina, Shenzhen, Guangdong 518040 (CN); WANG, Yingxu, Shenzhen, Guangdong 518040 (CN); AO, Dongfei, Shenzhen, Guangdong 518040 (CN)
(74) Representative: Goddar, Heinz J.
(86) International application number: PCT/CN2023/136374
(87) International publication number: WO 2024/187841

(57) **Abstract**

This application provides a rotating shaft mechanism and a foldable electronic device. The rotating shaft mechanism supports (a first bending segment of) a flexible circuit board through outer support plates by structurally designing support plate assemblies. Multiple support protrusions are designed on the side surface of each outer support plate facing the flexible circuit board (the side surface facing away from a foldable screen). The support protrusions are arranged on the side of the outer support plate close to an inner support plate. All support protrusions are sequentially arranged along a width direction of the outer support plate. The flexible circuit board is supported by using the support protrusions. Therefore, the redundant space of the flexible circuit board can be significantly increased without affecting the stiffness of the support plate assemblies or decorative plates, the bending radius of the first bending segment of the flexible circuit board can be increased, and the flexible circuit board can be bent more gently on the whole, improving the reliability and service life of the flexible circuit board. In addition, by combining the multiple support protrusions to control the bending radius of the first bending segment, the bending requirements of flexible circuit boards with different redundant lengths can be met.

## Description

This application claims priority to Chinese Patent Application No. 202310290599.6, entitled "ROTATING SHAFT MECHANISM AND FOLDABLE ELECTRONIC DEVICE" and filed with the China National Intellectual Property Administration on March 13, 2023, which is incorporated herein by reference in its entirety.

### TECHNICAL FIELD

This application relates to the technical field of electronic devices, and in particular, to a rotating shaft mechanism and a foldable electronic device.

### BACKGROUND

Foldable electronic devices, which can switch between an unfolded state and a folded state, have the advantages of large screen display and portability, making them increasingly popular among consumers.

Two main bodies of the foldable electronic device are connected by a rotating shaft mechanism. The relative rotation between the two main bodies is achieved through the movement of the rotating shaft mechanism, so as to switch the foldable electronic device between the unfolded state and the folded state. In the foldable electronic device, a flexible circuit board needs to pass through the rotating shaft mechanism to connect circuit boards in the two main bodies. In the repeated folding process of the whole device, the portion of the flexible circuit board located in the rotating shaft mechanism will also be bent repeatedly. Therefore, the flexible circuit board usually needs reserved deformation allowance to meet the reliability requirement of the flexible circuit board.

However, with the trend of ultra-thinning of the foldable electronic device, the redundant space for accommodating the flexible circuit board in the rotating shaft mechanism is becoming smaller and smaller, and the flexible circuit board is prone to small-angle bending, affecting the reliability and service life of the flexible circuit board.

### SUMMARY

This application provides a rotating shaft mechanism and a foldable electronic device. The rotating shaft mechanism can increase the redundant space of the flexible circuit board, avoid the small-angle bending of the flexible circuit board, make the flexible circuit board bent more gently, and improve the reliability and service life of the flexible circuit board.

According to one aspect, this application provides a rotating shaft mechanism applied to a foldable electronic device and having an unfolded state and a folded state. The rotating shaft mechanism includes:
a main shaft;
inner support plates, movably connected to two sides of a width direction of the main shaft; and
outer support plates, located on the two sides of the width direction of the main shaft and movably connected to a side of each inner support plate facing away from the main shaft, where
a side surface of each outer support plate facing away from a foldable screen of the foldable electronic device is provided with multiple support protrusions, the multiple support protrusions are located on a side of each outer support plate close to the inner support plate, all support protrusions are sequentially arranged along a width direction of each outer support plate, and at least some of the support protrusions are configured to support a flexible circuit board passing through the rotating shaft mechanism.

The rotating shaft mechanism provided in this application supports (a first bending segment of) the flexible circuit board through the outer support plates by structurally designing support plate assemblies. Multiple support protrusions are designed on the side surface of the outer support plate facing the flexible circuit board (the side surface facing away from the foldable screen). The support protrusions are arranged on the side of the outer support plate close to the inner support plate. All support protrusions are sequentially arranged along the width direction of the outer support plate. The flexible circuit board is supported by using the support protrusions. Therefore, the redundant space of the flexible circuit board can be significantly increased without affecting the stiffness of the support plate assemblies or decorative plates, the bending radius of the first bending segment of the flexible circuit board can be increased, and the flexible circuit board can be bent more gently on the whole, thus preventing the flexible circuit board from being layered, improving the reliability and service life of the flexible circuit board, and eliminating the abnormal noise in the movement process of the flexible circuit board. In addition, by combining the multiple support protrusions to control the bending radius of the first bending segment, the bending requirements of flexible circuit boards with different redundant lengths can be met.

In a possible implementation, an end of each support protrusion away from the outer support plate is provided with a protrusion vertex, and the protrusion vertex is configured to support the flexible circuit board.

By forming the protrusion vertex at the end of the support protrusion extending to the decorative plate, the support protrusion supports the flexible circuit board with the protrusion vertex. In this way, the outer support plates have accurate support positions for the flexible circuit board and the bending radius of the first bending segment of the flexible circuit board can be accurately controlled, thus avoiding the small-angle bending of the flexible circuit board and improving the service life and reliability of the flexible circuit board. Moreover, the support protrusions are in point contact with the flexible circuit board, the contact area is small, and the frictional force is small, thus reducing the abnormal noise caused by the movement of the flexible circuit board.

In a possible implementation, an end surface of each support protrusion away from the outer support plate is an arc-shaped surface, and the protrusion vertex is a vertex of the arc-shaped surface.

By designing a top surface of the support protrusion to be an ellipsoidal surface or a spherical surface, the top of the support protrusion form a smooth curved surface protruding towards the decorative plate. In this way, the support protrusion can disperse the force applied by the flexible circuit board to the protrusion vertex, thus avoiding local damage or tearing of the flexible circuit board due to stress concentration, and ensuring the reliability of the flexible circuit board.

In a possible implementation, the heights of the support protrusions gradually increases along a direction away from the inner support plate, where the height of each support protrusion is a distance from the protrusion vertex to a reference plane of the outer support plate, the reference plane is a plane where a straight segment of the side surface of the outer support plate facing away from the foldable screen is located, and the straight segment is perpendicular to the width direction of the main shaft when the rotating shaft mechanism is in the folded state.

By designing the heights of the support protrusions to gradually increase along the direction away from the inner support plate, the support protrusions can play a guiding role and can support the flexible circuit board to bend towards the direction of the decorative plate, allowing the flexible circuit board to transition from the first bending segment to the second bending segment.

In a possible implementation, the protrusion vertex of each support protrusion and a support point on an inner wall surface of each inner support plate for supporting the flexible circuit board are located on a preset circular arc-shaped surface, where the inner wall surface of the inner support plate is a side surface of the inner support plate facing away from the foldable screen.

By enabling the protrusion vertex of each support protrusion of the outer support plate and the support point on the inner wall surface of the inner support plate to be located on the preset circular arc-shaped surface, the preset circular arc-shaped surface may be a pre-designed arc with an appropriate bending radius, the bending radius of the first bending segment of the flexible circuit board can be accurately controlled, avoiding the small-angle bending of the flexible circuit board.

In a possible implementation, a difference between the radius of the preset circular arc-shaped surface and the thickness of the flexible circuit board is greater than 0.5 mm.

By designing the difference between the radius of the preset circular arc-shaped surface and the flexible circuit board to be greater than 0.5 mm, the small-angle bending of the flexible circuit board can be avoided, ensuring the service life and reliability of the flexible circuit board.

In a possible implementation, among the support protrusions, the support protrusion closest to the inner support plate is a proximal protrusion, the support protrusion farthest from the inner support plate is a distal protrusion, and at least one intermediate protrusion is provided between the proximal protrusion and the distal protrusion,

where on the preset circular arc-shaped surface, a central angle corresponding to an arc between the proximal protrusion and the support point is a first central angle, and the first central angle is greater than or equal to 45° and less than or equal to 65°; a central angle corresponding to an arc between the distal protrusion and the support point is a second central angle, and the second central angle is greater than or equal to 80° and less than or equal to 100°.

By configuring the first central angle corresponding to the proximal protrusion to be greater than or equal to 45° and less than or equal to 65°, a proper distance is kept between the proximal protrusion and the support point, ensuring that the flexible circuit board is stably supported, helping to adjust the bending radius of the first bending segment, and further facilitating the design of each subsequent support protrusion. By configuring the second central angle corresponding to the distal protrusion to be greater than or equal to 80° and less than or equal to 100°, an appropriate arc length is kept between the distal protrusion and the proximal protrusion, helping to arrange the intermediate protrusion between the two and combine the support protrusions according to the redundant length of the flexible circuit board.

In a possible implementation, the first central angle is 60°, and the second central angle is 90°.

In a possible implementation, one intermediate protrusion is provided between the proximal protrusion and the distal protrusion, a central angle corresponding to an arc between the intermediate protrusion and the support point is a third central angle, and the third central angle is greater than 65° and less than 80°.

By arranging one intermediate protrusion between the proximal protrusion and the distal protrusion, the different combinations of the three support protrusions can meet the requirements of flexible circuit boards with different redundant lengths. Moreover, by controlling the third central angle corresponding to the intermediate protrusion to be greater than 65° and less than 80°, the three support protrusions can support the flexible circuit board, accurately controlling the bending radius of the first bending segment of the flexible circuit board.

In a possible implementation, the third central angle is 75°.

By configuring the central angles corresponding to the proximal protrusion, the intermediate protrusion, and the distal protrusions to be respectively 60°, 75°, and 90°, the width range covered by each support protrusion on the outer support plate and the spacing between adjacent support protrusions are appropriate, meeting the requirements of flexible circuit boards with different redundant lengths through the combining of the support protrusions.

In a possible implementation, in a case that a redundancy factor of the flexible circuit board is within a first preset range, the proximal protrusion is in contact with the flexible circuit board;
in a case that the redundancy factor of the flexible circuit board is within a second preset range, the proximal protrusion and at least some of the intermediate protrusions are in contact with the flexible circuit board;
in a case that the redundancy factor of the flexible circuit board is within a third preset range, the proximal protrusion and the distal protrusion are in contact with the flexible circuit board,
where the maximum value of the first preset range is less than the minimum value of the second preset range, the maximum value of the second preset range is less than the minimum value of the third preset range, and the redundancy factor of the flexible circuit board is a percentage of the redundant length of the flexible circuit board to the reference length of the flexible circuit board.

According to the redundancy factor of the flexible circuit board, the combination of the support protrusions on the outer support plate is controlled to meet the requirements of flexible circuit boards with different redundant lengths. Regardless of the redundant length of the flexible circuit board, the proximal protrusion can always be in contact with the flexible circuit board. Moreover, the larger the redundancy factor of the flexible circuit board is, the larger the bending radius of the first bending segment of the flexible circuit board should be.

In a possible implementation, the first preset range is greater than 0 and less than or equal to 1, the second preset range is greater than 1 and less than or equal to 2, and the third preset range is greater than 2.

In a possible implementation, an outer wall surface of the support protrusion is a smooth wall surface that extends smoothly from the protrusion vertex to a surface of the outer support plate.

In a possible implementation, the width of the support protrusion gradually increases from the protrusion vertex to an end of the support protrusion connected to the outer support plate;
or, the support protrusion includes a transition segment and a straight rod segment connected sequentially from the protrusion vertex to the end of the support protrusion connected to the outer support plate, the width of the transition segment gradually increases, and the width of the straight rod segment remains unchanged.

In a possible implementation, each support protrusion includes a head and a rod portion from the protrusion vertex to an end of the support protrusion connected to the outer support plate, and a connecting portion between the head and the rod portion is a variable-diameter portion.

In a possible implementation, the width of the rod portion remains unchanged or gradually increases from an end of the rod portion connected to the head to the end of the rod portion connected to the outer support plate.

In a possible implementation, a gap exists between adjacent support protrusions, or adjacent support protrusions overlap with each other.

In a possible implementation, the rotating shaft mechanism further includes:
decorative plates, movably connected to the two sides of the width direction of the main shaft and arranged opposite to the inner support plates on the two sides of the thickness direction of the main shaft, where the decorative plates, the inner support plates and the outer support plates enclose to form a space for accommodating the flexible circuit board.

By movably connecting the decorative plates to the two sides of the width direction of the main shaft and arranging the decorative plates on the other side opposite to the support plate assemblies in the thickness direction of the main shaft, the decorative plates can play a role of covering the components connected between the main shaft and the support plate assemblies, improving the appearance attractiveness of the foldable electronic device. The space between the decorative plates and the support plate assemblies serves to accommodate the flexible circuit board passing through the rotating shaft mechanism.

In a possible implementation, the rotating shaft mechanism further includes:
a fixing assembly mounted to the main shaft and configured to fix the flexible circuit board.

In a possible implementation, the fixing assembly includes a first magnetic member and a second magnetic member arranged opposite to each other, and the first magnetic member and the second magnetic member are configured to clamp the flexible circuit board.

By arranging the first magnetic member and the second magnetic member and positioning the flexible circuit board through magnetic attraction, the flexible circuit board can be stably positioned without completely restricting the flexible circuit board. Under a larger force, the flexible circuit board can overcome the magnetic attraction and produce a small displacement, preventing the flexible circuit board from tearing or cracking.

According to another aspect, this application provides a foldable electronic device, which includes a first housing, a second housing, and the rotating shaft mechanism described above, where the first housing and the second housing are respectively connected to two sides of the rotating shaft mechanism.

The foldable electronic device provided in this application includes the first housing, the second housing, and the rotating shaft mechanism connected between the two. The rotating shaft mechanism supports (the first bending segment of) the flexible circuit board through the outer support plates by structurally designing support plate assemblies. Multiple support protrusions are designed on the side surface of the outer support plate facing the flexible circuit board (the side surface facing away from the foldable screen). The support protrusions are arranged on the side of the outer support plate close to the inner support plate. All support protrusions are sequentially arranged along the width direction of the outer support plate. The flexible circuit board is supported by using the support protrusions. Therefore, the redundant space of the flexible circuit board can be significantly increased without affecting the stiffness of the support plate assemblies or decorative plates, the bending radius of the first bending segment of the flexible circuit board can be increased, and the flexible circuit board can be bent more gently on the whole, thus preventing the flexible circuit board from being layered, improving the reliability and service life of the flexible circuit board, and eliminating the abnormal noise in the movement process of the flexible circuit board. In addition, by combining the multiple support protrusions to control the bending radius of the first bending segment, the bending requirements of flexible circuit boards with different redundant lengths can be met.

In a possible implementation, the foldable electronic device further includes a foldable screen, where the foldable screen is mounted on the first housing and the second housing, and the foldable screen is supported onto the rotating shaft mechanism, where
when the foldable electronic device is in the folded state, the first housing and the second housing are stacked relative to each other, and the foldable screen wraps around the first housing and the second housing.

### BRIEF DESCRIPTION OF DRAWINGS

FIG. 1 is a schematic structural diagram of a foldable electronic device in an unfolded state according to an embodiment of this application;
FIG. 2 is a schematic structural diagram of the foldable electronic device shown in FIG. 1 in a folded state;
FIG. 3 is an exploded schematic structural diagram of a foldable electronic device according to an embodiment of this application;
FIG. 4 is a partial schematic structural diagram of a foldable electronic device according to an embodiment of this application;
FIG. 5 is an enlarged structural diagram of the foldable electronic device in FIG. 4;
FIG. 6 is a schematic diagram of a flexible circuit board in a bent state according to one configuration of the prior art;
FIG. 7 is a schematic diagram of a flexible circuit board in a bent state according to another configuration of the prior art;
FIG. 8 is a schematic structural diagram of an outer support plate according to an embodiment of this application;
FIG. 9 is partial enlarged structural diagram of position A in FIG. 8;
FIG. 10 is a partial sectional view of FIG. 9;
FIG. 11 is a partial enlarged structural diagram of position A in FIG. 8;
FIG. 12 is a partial sectional view of FIG. 11;
FIG. 13 is a schematic structural diagram of some shapes of support protrusions according to an embodiment of this application;
FIG. 14 is a schematic structural diagram of other shapes of support protrusions according to an embodiment of this application;
FIG. 15 is a schematic structural diagram of yet other shapes of support protrusions according to an embodiment of this application;
FIG. 16 is a partial schematic structural diagram of a rotating shaft mechanism in an unfolded state according to an embodiment of this application;
FIG. 17 is a partial schematic structural diagram of a rotating shaft mechanism in a folded state according to an embodiment of this application;
FIG. 18 is a schematic diagram of the design of each support protrusions on an outer support plate according to an embodiment of this application;
FIG. 19 is a schematic diagram of the design of reference length of a flexible circuit board according to an embodiment of this application;
FIG. 20 is a partial schematic structural diagram of a rotating shaft mechanism applied in a simulated comparative example according to an embodiment of this application; and
FIG. 21 is a comparison result of simulation applying the rotating shaft mechanism in FIG. 20.

### Descriptions of reference numerals:

1-foldable electronic device;
10-housing assembly; 20-foldable screen; 30-flexible circuit board; 40-fixing assembly; 50-positioning sheet;
11-first housing; 12-second housing; 13-rotating shaft mechanism; 21-first region; 22-second region; 23-bendable region; 31-first bending segment; 32-second bending segment; 33-third bending segment; 41-first magnetic member; 42-second magnetic member;
100-main shaft; 200-inner support plate; 300-outer support plate; 400-decorative plate;
210-guide portion; 310-support protrusion;
310a-proximal protrusion; 310b-distal protrusion; 310c-intermediate protrusion;
311-transition segment; 312-straight rod segment; 313-head; 314-rod portion;
a-reference plane; b-horizontal plane; c-tangent plane; Q-support point

### DESCRIPTION OF EMBODIMENTS

Terms used in implementations of this application are merely intended to explain specific embodiments of this application, instead of limiting this application.

An embodiment of this application provides a foldable electronic device. The foldable electronic device may be a consumer electronic product. Exemplarily, the foldable electronic device includes, but not limited to, a mobile phone, a portable android device (portable android device, PAD), a notebook computer (notebook for short), an ultra-mobile personal computer (ultra-mobile personal computer, UMPC), a walkie-talkie, a netbook, a point of sales (Point of sales, POS) machine, a personal digital assistant (personal digital assistant, PDA), a wearable device, a virtual reality (virtual reality, VR) device, an augmented reality (augmented reality, AR) device, and the like.

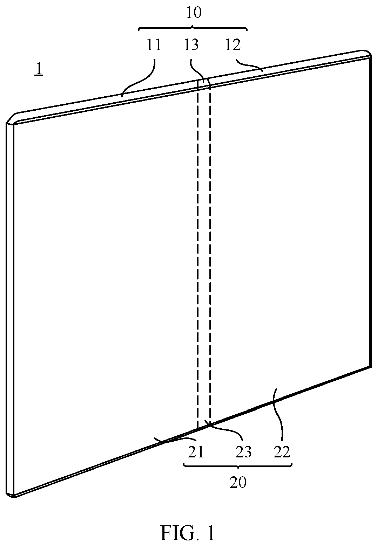

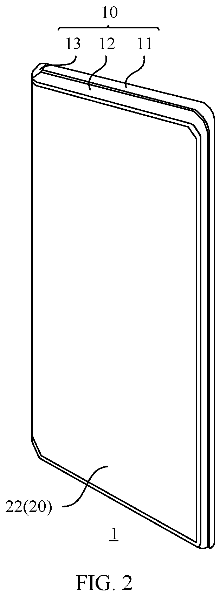

FIG. 1 is a schematic structural diagram of a foldable electronic device in an unfolded state according to an embodiment of this application. FIG. 2 is a schematic structural diagram of the foldable electronic device shown in FIG. 1 in a folded state. Referring to FIG. 1 and FIG. 2, this embodiment will be described by taking the foldable electronic device 1 being a foldable mobile phone as an example.

For the foldable electronic device 1, in different use scenarios, the foldable electronic device 1 may have different use states. FIG. 1 shows the foldable electronic device 1 in an unfolded state. An unfolding angle α of the foldable electronic device 1 is, for example, 180°. In this case, the foldable electronic device 1 may implement large-screen display. FIG. 2 shows the foldable electronic device 1 in a folded state. At this time, the volume of the foldable electronic device 1 is relatively small and it can be conveniently carried.

It needs to be stated that the angles described in this embodiment by examples allow for slight deviations. For example, the unfolding angle α of the foldable electronic device 1 shown in FIG. 1 being 180° means that the unfolding angle α may be 180° or approximately 180°, such as 170°, 175°, 185°, or 190°. The angles described below by examples can be understood in the same way.

In addition, the foldable electronic device 1 shown in FIG. 1 and FIG. 2 is a single-fold electronic device. The electronic device includes two parts that can rotate relative to each other. When the two parts are rotated to be coplanar, the foldable electronic device 1 is in the unfolded state (as shown in FIG. 1). When the two parts are rotated to be stacked together, the foldable electronic device 1 is in the folded state (as shown in FIG. 2). In other implementations, the foldable electronic device 1 may also be a multi-fold (two or more folds) electronic device. In this case, the foldable electronic device 1 may include multiple parts that are sequentially and rotatably connected. Adjacent two parts may get away from each other to be unfold to the unfolded state. Adjacent parts may also get close to each other to be folded to the folded state.

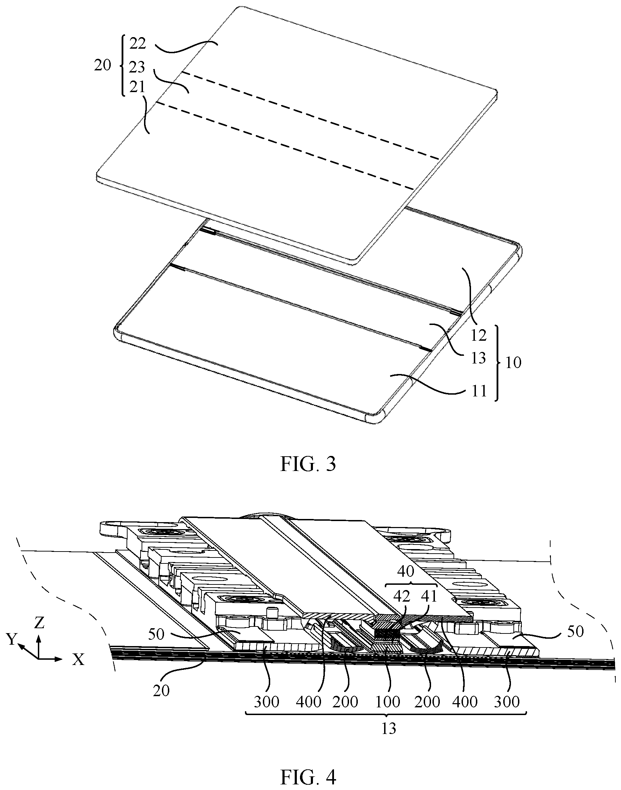

FIG. 3 is an exploded schematic structural diagram of a foldable electronic device according to this application. Referring to FIG. 3, the foldable electronic device 1 includes a housing assembly 10 and a foldable screen 20. The foldable screen 20 is supported and connected to one side surface of the housing assembly 10. A side surface of the foldable screen 20 facing away from the housing assembly 10 is its display surface (not shown). The display surface is configured to display information and provide an interactive interface for the user. In this embodiment, the display surface of the foldable screen 20 is defined as its front side, and the other side surface of the foldable screen 20 opposite to the front side is defined as its back side. That is to say, the front side of the foldable screen 20 is exposed outside the housing assembly 10, and the back side of the foldable screen 20 faces towards the housing assembly 10 and is connected to the housing assembly 10. Correspondingly, the side surface of the housing assembly 10 facing the foldable screen 20 is defined as the front side of the housing assembly 10, and the side surface of the housing assembly 10 facing away from the foldable screen 20 is defined as the back side of the housing assembly 10.

In this embodiment, the foldable screen 20 may be, but not limited to, an (organic light-emitting diode, OLED) display screen, an active-matrix organic light-emitting diode (active-matrix organic light-emitting diode, AMOLED) display screen, a mini organic light-emitting diode display screen, a micro light-emitting diode display screen, a micro organic light-emitting diode display screen, or quantum dot light emitting diodes (quantum dot light emitting diodes, QLED) display screen.

The foldable screen 20 may include a first region 21, a second region 22, and a bendable region 23. The bendable region 23 is located between the first region 21 and the second region 22. During the use of the foldable electronic device 1, the first region 21 and the second region 22 maintain a planar state at all times, while the bendable region 23 can be bent to change the included angle between the first region 21 and the second region 22. In this way, the foldable screen 20 can be folded or unfolded with the movement of the housing assembly 10, so as to achieve the switching between the folded state and the unfolded state of the foldable electronic device 1.

Exemplarily, in the foldable screen 20, at least the bendable region 23 is made of a flexible material, so that the bendable region 23 can be bent. The first region 21 and the second region 22 may be made of flexible materials, may be made of rigid materials, or may be partially made of rigid materials and partially made of flexible materials, which are not limited in this embodiment.

Under the drive of the housing assembly 10, the foldable screen 20 can switch between the unfolded state and the folded state. As shown in FIG. 1 and FIG. 3, when the foldable screen 20 is in the unfolded state, the first region 21 and the second region 22 are in an unfolded state in which they are away from each other, the bendable region 23 is in a flattened state without bending, and the first region 21, the second region 22, and the bendable region 23 face the same direction and are in a coplanar state. At this time, the included angle between the first region 21 and the second region 22 is 180°, and the foldable screen 20 can achieve large screen display, providing richer information for the user and bringing a better user experience to the user.

As shown in FIG. 2 and FIG. 3, when the foldable screen 20 is in the folded state, the first region 21 and the second region 22 are stacked together, and the bendable region 23 is in a bent state. The bending angle of the bendable region 23 is, for example, 180°. At this time, the foldable electronic device 1 is relatively small in size and can be conveniently carried and stored.

It should be stated that the foldable electronic device 1 shown in the figure is an outward-folding electronic device. When in the folded state, the first region 21 and the second region 22 of the foldable screen 20 are arranged back-to-back, the housing assembly 10 is located between the first region 21 and the second region 22, and the foldable screen 20 wraps around the housing assembly 10 and visible to the user. When the outward-folding electronic device is in the folded state, the foldable screen 20 is exposed, achieving a display function via the foldable screen 20. Therefore, there is no need to add a display screen on the back side of the housing to achieve the display function of the foldable electronic device 1 in the folded state.

In other examples, the foldable electronic device 1 may also be an inward-folding electronic device. When in the folded state, the first region 21 and the second region 22 of the foldable screen 20 are in contact, the bendable region 23 may be in the bent state, and the housing assembly 10 protects the foldable screen 20 externally to prevent the foldable screen 20 from being scratched by a hard object. In a case that the inward-folding electronic device needs to achieve the display function in the folded state, a display screen may be added to the back side of the housing. The foldable electronic device 1 achieves the display function in the folded state through this display screen.

In addition, in some embodiments, the foldable electronic device 1, especially the inward-folding electronic device, may hover at an angle between the unfolded state and the folded state. For example, the hovering angle of the foldable electronic device 1 may be 120°, 130°, 140°, or 150°. Through the damping force provided by the housing assembly 10, the housing assembly 10 may hover in a semi-unfolded state between the folded state and the unfolded state, and the foldable screen 20 stays in the semi-unfolded state with the housing assembly 10. At this time, the bendable region 23 of the foldable screen 20 is also in the bent state, and the bending extent of the bendable region 23 is smaller than that in the folded state. The first region 21 and the second region 22 of the foldable screen 20 are relatively inclined, and the included angle between the first region 21 and the second region 22 is, for example, 120°, 130°, 140°, or 150°.

The housing assembly 10 is configured to support and fix the foldable screen 20, and drive the foldable screen 20 to switch between the folded state and the unfolded state. Referring to FIG. 3, the housing assembly 10 includes a first housing 11, a second housing 12, and a rotating shaft mechanism 13. The rotating shaft mechanism 13 is connected between the first housing 11 and the second housing 12. The first housing 11 and the second housing 12 are rotatably connected through the rotating shaft mechanism 13, achieving the relative rotation between the first housing 11 and the second housing 12.

The first housing 11 supports and fixes the first region 21 of the foldable screen 20, and the second housing 12 supports and fixes the second region 22 of the foldable screen 20. In other words, the first region 21 of the foldable screen 20 is fixedly connected to the first housing 11, the second region 22 of the foldable screen 20 is fixedly connected to the second housing 12, and the bendable region 23 of the foldable screen 20 is arranged corresponding to the rotating shaft mechanism 13. When the rotating shaft mechanism 13 drives the first housing 11 and the second housing 12 to rotate relative to each other, the orientation of the first region 21 and the second region 22 of the foldable screen 20 changes correspondingly, and the bendable region 23 of the foldable screen 20 is bent or flatten with the change in the orientation of the first region 21 and the second region 22.

The rotating shaft mechanism 13 drives the first housing 11 and the second housing 12 to rotate relative to each other, causing the foldable electronic device 1 to switch between the folded state and the unfolded state. The first housing 11 and the second housing 12 may rotate along a direction of getting away from each other until they are coplanar. At this time, the housing assembly 10 is in the unfolded state, and the foldable screen 20 is in the unfolded state with the unfolding of the housing assembly 10, as shown in FIG. 1. The first housing 11 and the second housing 12 may also rotate along a direction of getting close to each other until they are stacked together. At this time, the housing assembly 10 is in the folded state, and the foldable screen 20 is in the folded state with the folding of the housing assembly 10, as shown in FIG. 2.

Exemplarily, the first housing 11 may have a support surface facing the first region 21 of the foldable screen 20, and the first region 21 of the foldable screen 20 is mounted to the support surface of the first housing 11. For example, the first region 21 of the foldable screen 20 is bonded to the support surface of the first housing 11. Similarly, the second housing 12 may have a support surface facing the second region 22 of the foldable screen 20, and the second region 22 of the foldable screen 20 is mounted to the support surface of the second housing 12. For example, the second region 22 of the foldable screen 20 is bonded to the support surface of the second housing 12.

The first housing 11 and the second housing 12 may each include a middle frame (not shown) and a rear cover (not shown). The middle frame is connected between the foldable screen 20 and the rear cover. A side surface of the middle frame facing the foldable screen 20 forms the support surface described above. The foldable screen 20 may be mounted to the side surface of the middle frame. The rear cover is connected to a side of the middle frame facing away from the foldable screen 20. The middle frame and the rear cover jointly enclose to form an accommodating space. The accommodating space is used for mounting some functional components (not shown) of the foldable electronic device 1.

The accommodating space of the housing assembly 10 is used for mounting some components such as circuit boards, batteries, camera modules, microphones, and speakers. Exemplarily, circuit boards may be arranged in both the first housing 11 (the accommodating space enclosed by the middle frame and rear cover of the first housing 11) and the second housing 12 (the accommodating space enclosed by the middle frame and rear cover of the second housing 12). A battery used for supplying power the components may be arranged only in the first housing 11 or the second housing 12, or batteries may be arranged in both the first housing 11 and the second housing 12. As for other components such as the camera module, the microphones and the speakers, they may be collectively arranged in the first housing 11 or the second housing 12, or some components may be arranged in the first housing 11 and some components may be arranged in the second housing 12.

As for the electrical connection between the circuit board inside the first housing 11 and the circuit board inside the second housing 12, usually, the circuit board inside the first housing 11 and the circuit board inside the second housing 12 are electrically connected, other components inside the first housing 11 are connected to the circuit board inside the first housing 11, and other components inside the second housing 12 are connected to the circuit board inside the second housing 12, achieving the electrical connection between the components. Usually, a flexible circuit board 30 (Flexible Printed Circuit, FPC for short) is arranged and connected between the circuit board inside the first housing 11 and the circuit board inside the second housing 12. The flexible circuit board 30 passes through the rotating shaft mechanism 13 and extends into the first housing 11 and the second housing 12 to achieve the connection between the circuit boards. Exemplarily, two ends of the flexible circuit board 30 may be connected to the circuit board inside the first housing 11 and the circuit board inside the second housing 12 through Board to Board (BTB) connectors.

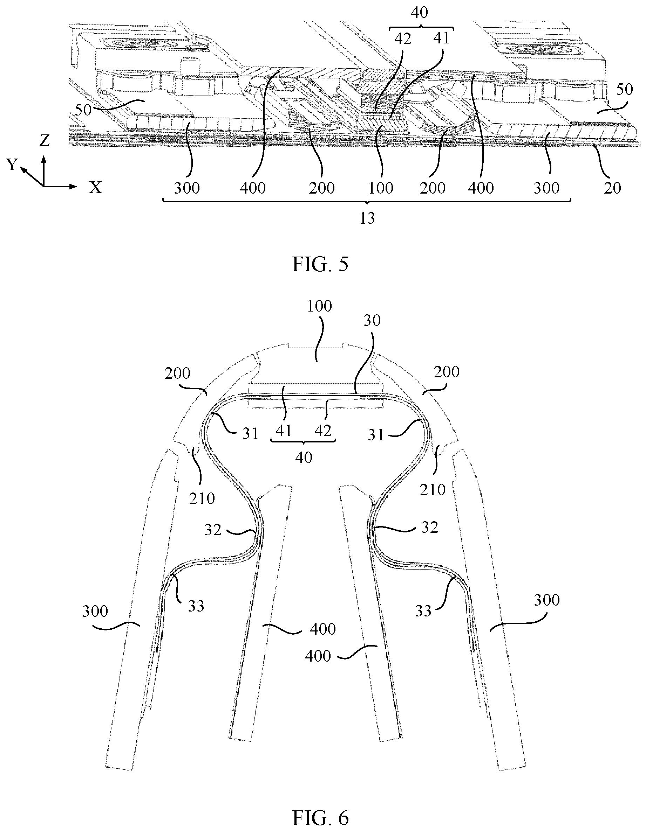

FIG. 4 is a partial schematic structural diagram of a foldable electronic device according to an embodiment of this application; FIG. 5 is an enlarged structural diagram of the foldable electronic device in FIG. 4.

This embodiment will be described by taking the foldable electronic device 1 being an outward-folding electronic device as an example. Referring to FIG. 4, which shows a partial structure of the rotating shaft mechanism 13 and the foldable screen 20 of the foldable electronic device 1, the foldable screen 20 is supported on one side of the thickness direction (Z direction shown in the figure) of the rotating shaft mechanism 13. As described above, the bendable region 23 of the foldable screen 20 corresponds to the rotating shaft mechanism 13. With the unfolding and folding of the rotating shaft mechanism 13, the bendable region 23 of the foldable screen 20 switches between the flattened state and the bent state.

The first housing 11 and the second housing 12 are not shown in the figure. It should be understood that the first housing 11 and the second housing 12 are respectively connected on two sides of the width direction of the rotating shaft mechanism 13 (as shown in FIG. 3). The first region 21 and the second region 22 of the foldable screen 20 are respectively attached to the first housing 11 and the second housing 12. With the unfolding and folding of the rotating shaft mechanism 13, the first housing 11 and the second housing 12 move relative to each other, driving the first region 21 and the second region 22 of the foldable screen 20 to move relative to each other.

For the outward-folding electronic device, when the foldable electronic device 1 is in the folded state, the foldable screen 20 wraps around the rotating shaft mechanism 13 (see FIG. 2), and the bending radius of the bendable region 23 of the foldable screen 20 is larger, and the width of the bendable region 23 (the dimension in the X direction shown in FIG. 4) is also larger. Correspondingly, the width of the rotating shaft mechanism 13 supporting the bendable region 23 of the foldable screen 20 (the dimension in the X direction shown in FIG. 4) is usually larger, and the space required by the rotating shaft mechanism 13 to move in its width direction is usually larger, so as to meet the bending requirement of the bendable region 23 of the foldable screen 20 and ensure stable support for the bendable region 23 of the foldable screen 20.

Referring to FIG. 5, the rotating shaft mechanism 13 typically includes a main shaft 100 and support plate assemblies. The main shaft 100 is located between the first housing 11 and the second housing 12 (as shown in FIG. 3). The main shaft 100 may extend along the edges of opposite sides of the first housing 11 and the second housing 12 (the Y direction in the figure). The main shaft 100, as a main support structure of the rotating shaft mechanism 13, is equivalent to a rotating shaft of the first housing 11 and the second housing 12. The first housing 11 and the second housing 12 rotate around the main shaft 100 (along the length direction). During the movement of the rotating shaft mechanism 13, the main shaft 100 may be fixed, and a region of the bendable region 23 of the foldable screen 20 corresponding to the main shaft 100 may be fixedly connected (e.g., bonded) to the main shaft 100. The support plate assemblies are movably connected to two sides of the width direction (the X direction in the figure) of the main shaft 100. The support plate assemblies located on two sides of the main shaft 100 can move relative to the main shaft 100, so as to achieve the switching of the rotating shaft mechanism 13 between the unfolded state and the folded state.

The support plate assemblies can rotate along the angular direction relative to the main shaft 100. The support plate assemblies located on the two sides of the main shaft 100 can move relative to each other about the main shaft 100 as the center. Exemplarily, surfaces of the support plate assemblies on the two sides of the main shaft 100 can be get away from each other, so that the support plate assemblies are unfolded on the two sides of the main shaft 100 and the support plate assemblies on the two sides of the main shaft 100 are coplanar with the main shaft 100. At this time, the rotating shaft mechanism 13 is in the unfolded state, and the foldable electronic device 1 is also in the unfolded state (see FIG. 1). The surfaces of the support plate assemblies on the two sides of the main shaft 100 can be get close to each other, so that the support plate assemblies on the two sides (of the width direction) of the main shaft 100 are folded on one side (of the thickness direction) of the main shaft 100. At this time, the support plate assemblies on the two sides of the main shaft 100 are almost perpendicular to (the plane direction of) the main shaft 100 and are arranged opposite to each other. At this time, the rotating shaft mechanism 13 is in the folded state, and the foldable electronic device 1 is also in the folded state (see FIG. 2).

With continued reference to FIG. 5, in a case that the foldable electronic device 1 is an outward-folding electronic device, each support plate assembly usually includes an inner support plate 200 and an outer support plate 300. The inner support plates 200 and the outer support plates 300 are both located on the two sides of the width direction of the main shaft 100, and the outer support plate 300 is located on a side of the corresponding inner support plate 200 facing away from the main shaft 100. In other words, the inner support plate 200 is located between the main shaft 100 and the outer support plate 300, and both the inner support plate 200 and the outer support plate 300 can move relative to the main shaft 100, so as to achieve the switching of the rotating shaft mechanism 13 between the unfolded state and the folded state. Exemplarily, the rotating shaft mechanism 13 may be connected to the first housing 11 and the second housing 12 respectively through the outer support plates 300 on the two sides. For example, the first housing 11 and the second housing 12 are locked together with the corresponding outer support plates 300 by screws, rivets, and the like, so as to drive the first housing 11 and the second housing 12 to move relative each other through the outer support plates 300 on the two sides.

The inner support plates 200 and the outer support plates 300 are arranged to jointly support the bendable region 23 of the foldable screen 20. On the one hand, the inner support plates 200 and the outer support plates 300 occupy a larger planar space, which can increase the size of the rotating shaft mechanism 13 in its width direction. The support plate assemblies can stably support the bendable region 23 of the foldable screen 20 to ensure the flatness of the bendable region 23 of the foldable screen 20 in the flattened state, so that the bendable region 23 of the foldable screen 20 can smoothly transition to the bent state. On the other hand, during the switching of the rotating shaft mechanism 13 between the unfolded state and the folded state, the inner support plates 200 and the outer support plates 300 sequentially and continuously change their attitudes, making the attitude of the support plate assemblies more flexible and meeting the requirement of a large bending radius for the bendable region 23 of the foldable screen 20. Especially in the folded state, the bendable region 23 of the foldable screen 20 can be stably supported, so as to improve the smoothness of the bendable region 23 of the foldable screen 20 in the bent state.

During the switching of the rotating shaft mechanism 13 from the unfolded state to the folded state, the surfaces of the outer support plates 300 on the two sides of the main shaft 100 get close to each other until the outer support plates 300 on the two sides are approximately parallel to each other, so as to drive the foldable screen 20 to switch to the folded state. At the same time, the outer support plates 300 on the two sides of the main shaft 100 translate towards the direction of getting close to the main shaft 100 in the plane direction, so as to meet the spatial change requirement of the bendable region 23 of the foldable screen 20 from the flattened state to the bent state. During the switching of the rotating shaft mechanism 13 from the folded state to the unfolded state, the surfaces of the outer support plates 300 on the two sides of the main shaft 100 get away from each other until the outer support plates 300 on the two sides are approximately coplanar with the main shaft 100, so as to drive the foldable screen 20 to switch to the flattened state. At the same time, the outer support plates 300 on the two sides of the main shaft 100 translate towards the direction of getting away from the main shaft 100 in the plane direction, so as to meet the spatial change requirement of the bendable region 23 of the foldable screen 20 from the bent state to the flattened state. As for the inner support plates 200 between the outer support plates 300 and the main shaft 100, the inner support plates 200 may have a large free movement space and change the attitude according to the bending state of the corresponding region of the bendable region 23 of the foldable screen 20, so as to stably support the corresponding region of the bendable region 23.

In order to achieve the movement of the support plate assembly relative to the main shaft 100, the rotating shaft mechanism 13 usually further includes transmission swing arms (not shown). The transmission swing arms are connected between the main shaft 100 and the support plate assemblies. For example, one end of each transmission swing arm is movably (rotatably, slidably, or rotatably and slidably) connected to the main shaft 100, and the other end of each transmission swing arm is movably (rotatably, slidably, or rotatably and slidably) connected to the corresponding outer support plate 300. The inner support plates 200 are fixed through the transmission swing arms. The inner support plates 200 flexibly change the attitude with the movement of the transmission swing arms. By driving the support plate assemblies to rotate and translate relative to the main shaft 100 through the transmission swing arms, the rotating shaft mechanism 13 can switch between the unfolded state and the folded state, thus driving the housing assembly 10 to switch between the unfolded state and the folded state.

In addition to the transmission swing arms, usually, other components such as synchronization assemblies (not shown) and damping assemblies (not shown) are further connected between the main shaft 100 and the support plate assemblies on the two sides. The synchronization assemblies configured to maintain the synchronous movement of the support plate assemblies on the two sides of the main shaft 100 relative to the main shaft 100, so as to achieve the synchronous movement of the first housing 11 and the second housing 12. The damping assemblies are used for providing a damping force, ensuring the stability of the housing assembly 10 in the unfolded state, the folded state, and the switching between the two states. Exemplarily, both the synchronization assemblies and the damping assemblies may be connected between the main shaft 100 and the outer support plates 300.

With continued reference to FIG. 5, for the outward-folding electronic device, the rotating shaft mechanism 13 may further include decorative plates 400. The decorative plates 400 are also movably connected to the two sides of the width direction of the main shaft 100. Unlike the support plate assemblies, the decorative plates 400 may be connected on the other side of the thickness direction (the Z direction shown in the figure) of the main shaft 100. The decorative plates 400 mainly serve to cover the internal structure of the rotating shaft mechanism 13. For example, the decorative plates 400 may cover components such as the transmission swing arms, the synchronization assemblies and the damping assemblies connected between the main shaft 100 and the support plate assemblies, so as to improve the appearance attractiveness of the foldable electronic device 1 (especially in the unfolded state).

The decorative plates 400 may be connected only to the main shaft 100, without being connected to components such as the outer support plates 300, the first housing 11, or the second housing 12, so as to avoid restricting the movement of the housing assembly 10 driven by the rotating shaft mechanism 13. Exemplarily, the decorative plates 400 may be connected to the main shaft 100 through hinges, so as to meet the requirement that the decorative plates 400 on the two sides of the main shaft 100 rotate relative to the main shaft 100.

For the flexible circuit board 30 (not shown in FIG. 4 and FIG. 5) that passes through the rotating shaft mechanism 13, the flexible circuit board 30 passes through the main shaft 100, and the portions of the flexible circuit board 30 located on the two sides of the main shaft 100 are accommodated in the spaces enclosed between the support plate assemblies and the decorative plates 400. Exemplarily, the middle segment of the flexible circuit board 30 corresponding to the main shaft 100 may be fixed on the main shaft 100, so as to position the flexible circuit board 30 through the main shaft 100. The portions of the flexible circuit board 30 corresponding to the outer support plates 300 on the two sides may be respectively fixed on the corresponding outer support plates 300. The portions of the flexible circuit board 30 extending from the outer support plates 300 to the corresponding sides of the housing assembly 10 may be relatively fixed inside the housing assembly 10. Segments of the flexible support board located between the outer support plates 300 and the main shaft 100 may change the shape with the switching of the rotating shaft mechanism 13 between the unfolded state and the folded state, and the spaces between the main shaft 100 and the outer support plates 300 define the deformation range of the flexible circuit board 30.

A fixing assembly 40 is arranged on the main shaft 100 and the flexible circuit board 30 is fixed through the fixing assembly 40, so that a segment of the flexible circuit board 30 corresponding to the main shaft 100 is relatively fixed to the main shaft 100, so as to position the flexible circuit board 30. Referring to FIG. 5, as an example, the fixing assembly 40 may include a first magnetic member 41 and a second magnetic member 42. The first magnetic member 41 and the second magnetic member 42 may be arranged opposite to each other along the thickness direction (the Z direction in the figure) of the main shaft 100. The first magnetic member 41 and the second magnetic member 42 are fixed to the main shaft 100. For example, the first magnetic member 41 and the second magnetic member 42 are bonded to the main shaft 100. The flexible circuit board 30 is located between the first magnetic member 41 and the second magnetic member 42. Through the magnetic attraction between the first magnetic member 41 and the second magnetic member 42, the flexible circuit board 30 is tightly fit between the two, so as to fix the flexible circuit board 30.

By arranging the first magnetic member 41 and the second magnetic member 42 and positioning the flexible circuit board 30 through magnetic attraction, the flexible circuit board 30 can be stably positioned without completely restricting the flexible circuit board 30. Under a larger force, the flexible circuit board 30 can overcome the magnetic attraction and produce a small displacement, preventing the flexible circuit board 30 from tearing or cracking. Exemplarily, along the thickness direction of the main shaft 100, at least partial region of the main shaft 100 may consist of at least two portions, and the first magnetic member 41 and the second magnetic member 42 may be respectively mounted at different portions.

Of course, in addition to fixing the flexible circuit board 30 through magnetic attraction, in other examples, the flexible circuit board 30 may also be clamped inside the main shaft 100 by pressure, or the flexible circuit board 30 is directly bonded to the main shaft 100, as long as it can ensure that the flexible circuit board 30 will not be excessively pulled or torn during the long-term use of the foldable electronic device 1, which is not specifically limited in this embodiment.

As for the fixing of the portions of the flexible circuit board 30 corresponding to the outer support plates 300 on the outer support plates 300, with continued reference to FIG. 5, the flexible circuit board 30 is pressed inside the outer support plates 300 with positioning sheets 50. The positioning sheets 50 may be metal sheets sandwiched inside the outer support plates 300. Exemplarily, the outer support plates 300 may each consist of two portions arranged along the thickness direction. The two portions may be locked through locking components such as screws and bolts. Such arrangement facilitates the connection of the transmission swing arms, the synchronization assemblies and the damping assemblies with the outer support plates 300. The positioning sheets 50 may be sandwiched between two portions of the outer support plates 300. The flexible circuit board 30 is pressed between the positioning sheets 50 and any portion of the outer support plates 300.

Of course, similar to the fixation of the flexible circuit board 30 to the main shaft 100, the flexible circuit board 30 may also be positioned on the outer support plates 300 through magnetic attraction structures, or the flexible circuit board 30 may be directly bonded to the outer support plates 300, which will not be repeated here.

As described above, during the switching between the unfolded state and the folded state of the rotating shaft mechanism 13, the support plate assemblies on the two sides of the main shaft 100 need to be unfolded or folded relative to the main shaft 100, and the support plate assemblies also move towards or away from the main shaft 100 to change the spacing relative to the main shaft 100, meeting the spatial position requirement of the housing assembly 10 during the switching between the unfolded state and the folded state. For the flexible circuit board 30 passing through the rotating shaft mechanism 13, a region of the flexible circuit board 30 corresponding to the rotating shaft mechanism 13 needs to be repeatedly moved between the unfolded state and the bent state, and a particular amount of redundancy needs to be reserved for the flexible circuit board 30 to prevent tensile stress on the flexible circuit board 30 that could compromise its service life and operational stability. Exemplarily, considering the assembly tolerance fluctuation of the flexible circuit board 30, the flexible circuit board 30 generally requires an additional redundancy of 0.3 mm to 0.5 mm based on the basic length required in the unfolded state.

However, with the trend of lightweight development of the foldable electronic device 1, the rotating shaft mechanism 13 is also becoming thinner as the whole machine becomes ultra-thin. The redundant space inside the rotating shaft mechanism 13 for accommodating the flexible circuit board 30 is becoming smaller and smaller, which limits the bending of the flexible circuit board 30, especially for the outward-folding electronic device. This will significantly affect the shape of the flexible circuit board 30 in the bent state, affecting the service life of the flexible circuit board 30 and the use performance of the foldable electronic device 1.

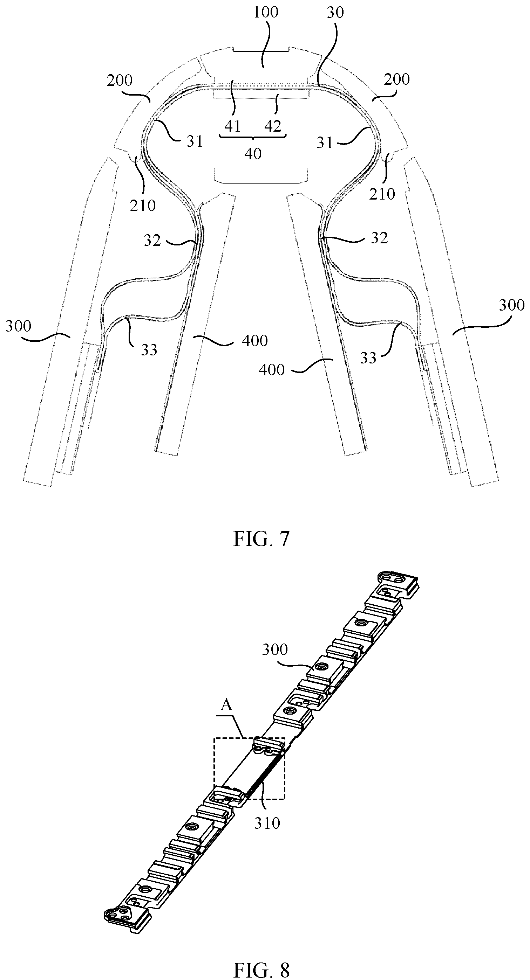

FIG. 6 is a schematic diagram of a flexible circuit board in a bent state according to one configuration of the prior art; FIG. 7 is a schematic diagram of a flexible circuit board in a bent state according to another configuration of the prior art.

Referring to FIG. 6, it shows a bending structure of the flexible circuit board 30 in a taut state when the rotating shaft mechanism 13 is in the folded state. For a deformation segment of the flexible circuit board 30 between the two outer support plates 300, the flexible circuit board 30 in the so-called taut state can be understood as a flexible circuit board 30 without an additional redundancy and with a length that just meets the required extension length between the two outer support plates 300 on the two sides when the rotating shaft mechanism 13 is in the unfolded state. In other words, the flexible circuit board 30 in the taut state, as the name suggests, refers to the flexible circuit board 30 being in a taut state when the rotating shaft mechanism 13 is in the unfolded state.

When the rotating shaft mechanism 13 is in the folded state, from the perspective of the structure of the flexible circuit board 30 on a single side (a deformation segment of the flexible circuit board 30 from the portion fixedly connected to the main shaft 100 to the portion fixedly connected to the outer support plate 300 on one side), from an end of the flexible circuit board 30 connected to the main shaft 100 to an end of the flexible circuit board 30 connected to the outer support plate 300, the flexible circuit board 30 sequentially includes a first bending segment 31, a second bending segment 32, and a third bending segment 33. The first bending segment 31 is tangent to the inner support plate 200, the second bending segment 32 is tangent to the decorative plate 400, and the third bending segment 33 is a bending segment inevitably formed when transitioning from the second bending segment 32 to the portion fixedly connected to the outer support plate 300.

The bending attitude of the first bending segment 31 of the flexible circuit board 30 determines the bending trend of the second bending segment 32 and the third bending segment 33. In other words, the bending radius of the first bending segment 31 determines the bending extent of the second bending segment 32 and the third bending segment 33. Exemplarily, in order to guide the bending of the flexible circuit board 30, an end of the inner support plate 200 facing the outer support plate 300 is usually provided with a guide portion 210. The guide portion 210 protrudes in a smooth arc shape towards the side where the decorative plate 400 is located, so as to guide the routing of the first bending segment 31 to the second bending segment 32. The guide portion 210 can limit the bending radius of the first bending segment 31.

Referring to FIG. 7, it shows a bending structure of the flexible circuit board 30 in a redundant state when the rotating shaft mechanism 13 is in the folded state. Also for the deformation segment of the flexible circuit board 30 between the two outer support plates 300, the flexible circuit board 30 in the so-called redundant state can be understood as a flexible circuit board 30 with an additional redundancy and with a length that is slightly larger than the required extension length between the two outer support plates 300 on the two sides when the rotating shaft mechanism 13 is in the unfolded state. In other words, the flexible circuit board 30 in the redundant state, as the name suggests, refers to the flexible circuit board 30 being in a relaxed state when the rotating shaft mechanism 13 is in the unfolded state.

When the rotating shaft mechanism 13 is in the folded state, from the perspective of the structure of the flexible circuit board 30 on a single side, since the length of the flexible circuit board 30 in the redundant state is slightly longer than that of the flexible circuit board 30 in the taut state, under the situation that the bending radius of the first bending segment 31 remains unchanged, the overall length occupied by the second bending segment 32 and the third bending segment 33 is longer, causing the bending radius of the second bending segment 32 and the third bending segment 33 to be smaller.

With continued reference to FIG. 7, with the development trend of ultra-thin form of the foldable electronic device 1, the thickness of the rotating shaft mechanism 13 is also decreasing, and the space between the outer support plate 300 and the decorative plate 400 is becoming narrower, causing the redundant space for accommodating the flexible circuit board 30 to become smaller and smaller, which may easily lead to small-angle bending of the flexible circuit board 30 (bending radius less than 0.5 mm), especially at the second bending segment 32 and the third bending segment 33. During the long-term use of the foldable electronic device 1, the flexible circuit board 30 is repeatedly bent, and small-angle bending may even develop into dead bending, which will affect the service life and reliability of the flexible circuit board 30.

Moreover, for the flexible circuit board 30 that is commonly designed with multiple layers (at least two layers), since the layers of the flexible circuit board 30 are naturally adhere to with air gaps in between, as the bending radius decreases, the flexible circuit board 30 will experience layering during bending (as shown at the second bending segment 32 in the figure). During the process of repeatedly unbending and bending the flexible circuit board 30, the attitude of the flexible circuit board 30 switches back and forth between adhesion and layering, thus causing abnormal noise in the flexible circuit board 30 and affecting the use performance of the foldable electronic device 1.

In order to increase the redundant space of the flexible circuit board 30, in the related technologies, the thickness of the inner support plate 200 and the decorative plate 400 is reduced usually, and even the thickness of the outer support plate 300 is reduced, so as to increase the spacing between the inner support plate 200 (outer support plate 300) and the decorative plate 400, increasing the bending radius of the first bending segment 31 and the bending radius of the second bending segment 32 of the flexible circuit board 30. However, this method will cause the stiffness of the inner support plate 200 and the decorative plate 400 (as well as the outer support plate 300) to decrease, resulting in a risk of fracture of the support plate assembly (decorative plate 400) when the entire foldable electronic device 1 collides or falls.

In view of this, in this embodiment of this application, (the first bending segment 31 of) the flexible circuit board 30 is supported through outer support plates 300 by structurally designing the support plate assemblies, multiple support protrusions are designed on the side surface of the outer support plate 300 facing the flexible circuit board 30 (the side surface facing away from the foldable screen 20), the support protrusions are arranged on the side of the outer support plate 300 close to the inner support plate 200, all support protrusions are sequentially arranged along the width direction of each outer support plate 300, and the flexible circuit board 30 is supported by using the support protrusions. Therefore, the redundant space of the flexible circuit board 30 can be significantly increased without affecting the stiffness of the support plate assemblies or decorative plates 400, the bending radius of the first bending segment 31 of the flexible circuit board 30 can be increased, and the flexible circuit board 30 can be bent more gently on the whole, improving the reliability and service life of the flexible circuit board 30. In addition, by combining the multiple support protrusions to control the bending radius of the first bending segment 31, the bending requirements of flexible circuit boards 30 with different redundant lengths can be met.

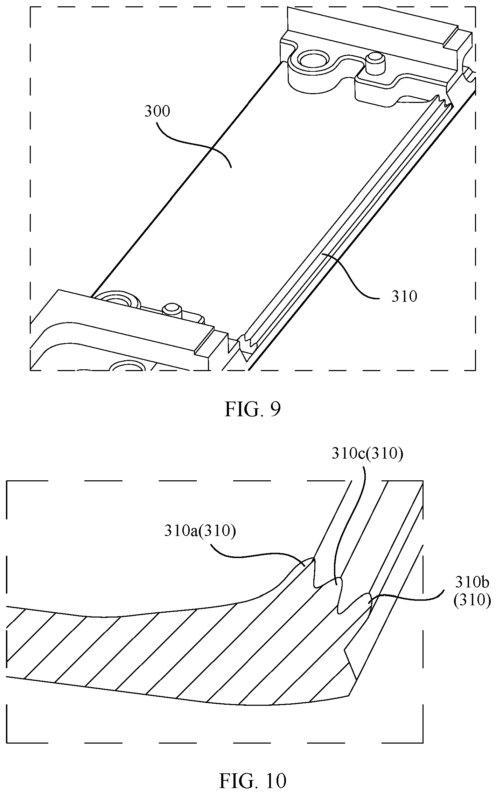

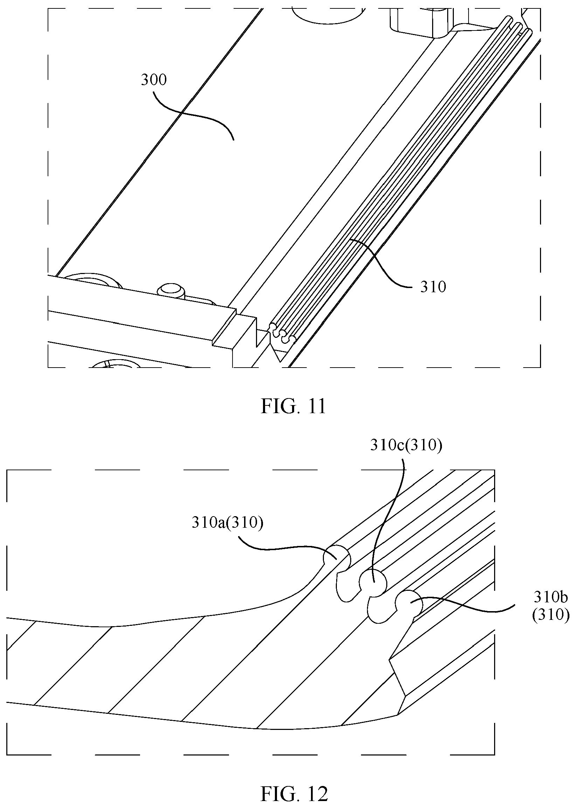

FIG. 8 is a schematic structural diagram of an outer support plate according to an embodiment of this application; FIG. 9 is partial enlarged structural diagram of position A in FIG. 8; FIG. 10 is a partial sectional view of FIG. 9; FIG. 11 is a partial enlarged structural diagram of position A in FIG. 8; FIG. 12 is a partial sectional view of FIG. 11.

Referring to FIG. 8, FIG. 9, and FIG. 11, in this embodiment, multiple support protrusions 310 are provided on the outer support plate 300 of the support plate assembly. The support protrusions 310 are arranged on a side surface of the outer support plate 300 facing away from the foldable screen 20, that is, the support protrusions 310 are arranged on the side surface of the outer support plate 300 facing the decorative plate 400, and the support protrusions 310 are correspondingly arranged in the region of the outer support plate 300 for the flexible circuit board 30 to pass through, so as to support the flexible circuit board 30 through the support protrusions 310. Exemplarily, the support protrusions 310 may be long strip-shaped structures. Along the length direction of the outer support plate 300, the support protrusions 310 at least cover the region where the flexible circuit board 30 is located, so as to stably support the flexible circuit board 30 through the support protrusions 310.

Exemplarily, the support protrusions 310 on the outer support plate 300 may be formed through a Computerized Numerical Control (CNC) machining process.

Referring to FIG. 9 and FIG. 10 (or FIG. 11 and FIG. 12), the support protrusions 310 are located on a side of the outer support plate 300 close to the inner support plate 200, and all support protrusions 310 are sequentially arranged along the width direction of the outer support plate 300. In other words, all support protrusions 310 are sequentially arranged along the direction away from the inner support plate 200. All support protrusions 310 are configured to support the flexible circuit board 30, and different combinations of the multiple support protrusions 310 can be adopted to meet the requirements of flexible circuit boards 30 with different redundant lengths. Exemplarily, in different application scenarios (when supporting flexible circuit boards 30 with different redundant lengths), among the multiple support protrusions 310, one support protrusion 310 may support the flexible circuit board 30, or two support protrusions 310 may support the flexible circuit board 30, or three or even all support protrusions 310 may support the flexible circuit board 30.

For the support protrusion 310 protruding from the outer support plate 300 to the decorative plate 400, this embodiment defines an end of the support protrusion 310 connected to the outer support plate 300 as its root, and an end of the support protrusion 310 extending towards the decorative plate 400 as its top. That is to say, the root of the support protrusion 310 is connected to the outer support plate 300, and the top of each support protrusion 310 extends towards the decorative plate 400.

An end of the support protrusion 310 away from the outer support plate 300 has a protrusion vertex. In other words, the top of the support protrusion 310 has a protrusion vertex. The support protrusions 310 uses its protrusion vertex to support the flexible circuit board 30, so that the flexible circuit board 30 is in contact with the protrusion vertex. Since the position of each support protrusion 310 on the outer support plate 300 is fixed and the height of each support protrusion 310 is also fixed, that is, the position of the protrusion vertex of the support protrusion 310 is fixed, by making the flexible circuit board 30 be in contact with the protrusion vertex of the support protrusion 310, the outer support plate 300 has a precise positioning point for the flexible circuit board 30, providing more stable support for the flexible circuit board 30, accurately controlling the bending radius of the first bending segment 31 of the flexible circuit board 30, and ensuring that the bending radius of the first bending segment 31 of the flexible circuit board 30 is within an appropriate range, so as to avoid the small-angle bending of the flexible circuit board 30 and improve the service life and reliability of the flexible circuit board 30.

Moreover, the support protrusion 310 utilizes its protrusion vertex to support the flexible circuit board 30, the flexible circuit board 30 and the support protrusion 310 are in point contact, and the contact area between the two is small, reducing the friction between the flexible circuit board 30 and the outer support plate 300, reducing the abnormal noise caused by friction, and improving the use performance of the foldable electronic device 1.

Referring to FIG. 10 or FIG. 12, in a case that the protrusion vertex is formed at the top of the support protrusion 310, in order to avoid stress concentration on the flexible circuit board 30 caused by the support protrusion 310, in this embodiment, a top surface of the support protrusion 310 may be designed as a smooth arc-shaped surface. For example, the top surface of the support protrusion 310 is an elliptical arc-shaped surface or a circular arc-shaped surface. A smooth arc-shaped surface that protrudes towards the decorative plate 400 is formed on the top of the support protrusion 310, so as to form a protrusion vertex at the top end of the support protrusion 310. In this way, when the flexible circuit board 30 is in contact with the protrusion vertex of the support protrusion 310, the support protrusion 310 can disperse the force applied by the flexible circuit board 30 to its protrusion vertex, avoiding local damage or tearing of the flexible circuit board 30 due to stress concentration and ensuring the reliability of the flexible circuit board 30.

Referring to FIG. 10, in some implementations, the top surface of the support protrusion 310 may be an elliptical arc-shaped surface, the cross-sectional shape of the top surface of the support protrusion 310 is an elliptical arc, and the protrusion vertex of the support protrusion 310 is the highest point of the elliptical arc-shaped surface. Referring to FIG. 12, in some other implementations, the top surface of the support protrusion 310 may be a circular arc-shaped surface, the cross-sectional shape of the top surface of the support protrusion 310 is a circular arc, and the protrusion vertex of the support protrusion 310 is the highest point of the circular arc-shaped surface.

With continued reference to FIG. 10 and FIG. 12, in this embodiment, among the support protrusions 310 on the outer support plate 300, the support protrusion 310 closest to the inner support plate 200 is defined as a proximal protrusion 310a, the support protrusion 310 farthest away from the inner support plate 200 is defined as a distal protrusion 310b, and the support protrusion 310 between the proximal protrusion 310a and the distal protrusion 310b is defined as an intermediate protrusion 310c. At least three support protrusions 310 are provided on the outer support plate 300, that is, there is at least one intermediate protrusion 310c is provided between the proximal protrusion 310a and the distal protrusion 310b. In this way, different combinations of the support protrusions 310 on the outer support plate 300 can meet the requirements of flexible circuit boards 30 with different redundant lengths.

Taking three support protrusions 310 being provided on the support plate as an example, the three support protrusions 310 are respectively a proximal protrusion 310a, an intermediate protrusion 310c, and a distal protrusion 310b. Of course, in other examples, two or more intermediate protrusions 310c may be arranged between the proximal protrusion 310a and the distal protrusion 310b. For example, two, three, or even more intermediate protrusions 310c are arranged between the proximal protrusion 310a and the distal protrusion 310b, which is not limited in this embodiment.

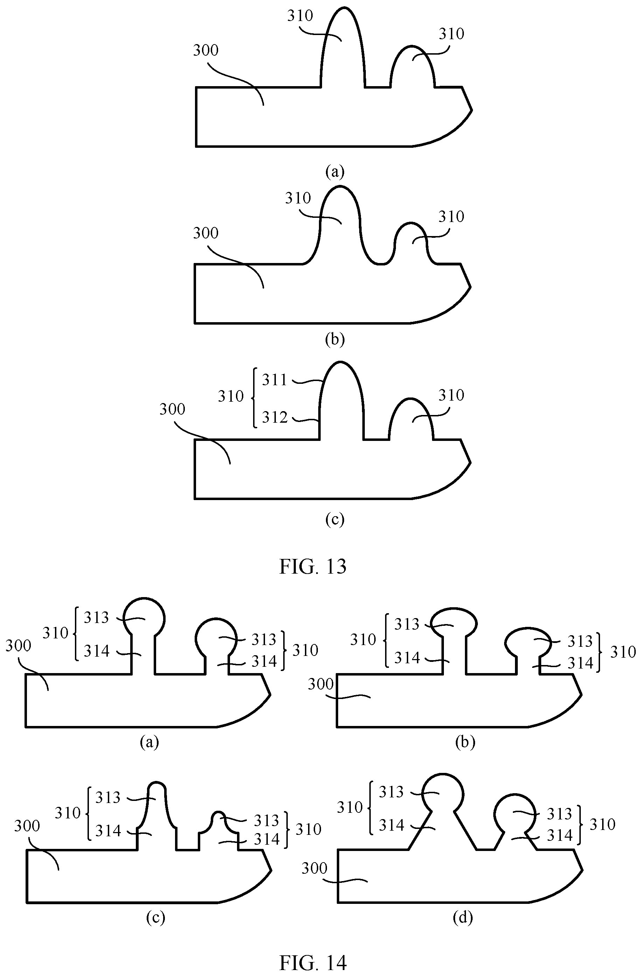

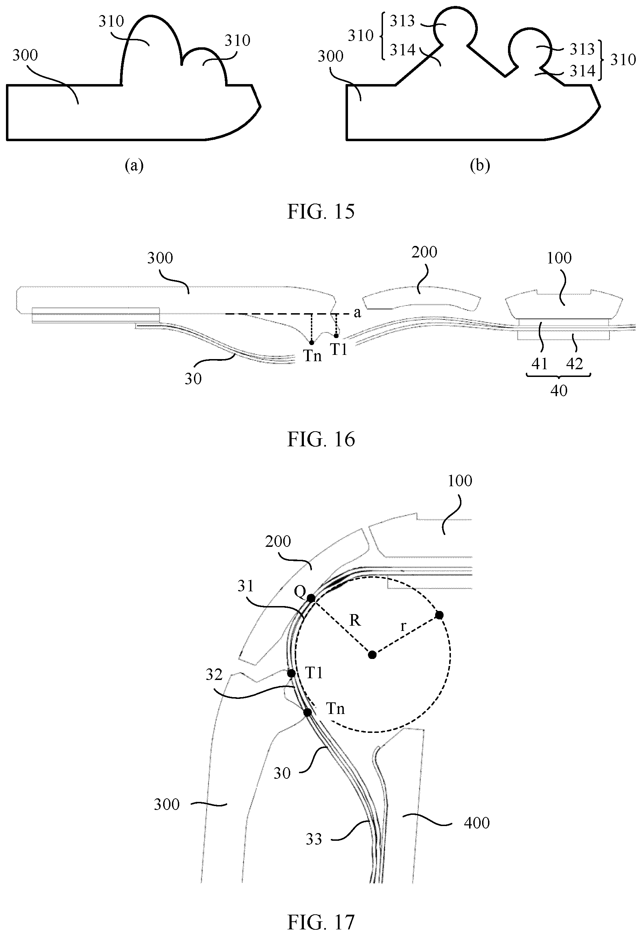

FIG. 13 is a schematic structural diagram of some shapes of support protrusions according to an embodiment of this application; FIG. 14 is a schematic structural diagram of other shapes of support protrusions according to an embodiment of this application; FIG. 15 is a schematic structural diagram of yet other shapes of support protrusions according to an embodiment of this application. Referring to FIG. 13 to FIG. 15, in this embodiment, the shapes of other portions of the support protrusion 310 are not limited except for that the top surface of the support protrusion 310 is a smooth arc-shaped surface such as elliptical arc-shaped surface or circular arc-shaped surface.

Referring to FIG. 13, as an example, an outer wall surface of the support protrusion 310 may be a smooth wall surface. In other words, from the protrusion vertex of the support protrusion 310 to the root of the support protrusion 310, the outer wall surface of the support protrusion 310 is a wall surface extending smoothly.

For example, referring to (a) of FIG. 13, from the protrusion vertex of the support protrusion 310 to the root of the support protrusion 310, the width of the support protrusion 310 (the dimension of the support protrusion 310 extending along the width direction of the outer support plate 300) gradually increases, and the rate of width increase of the support protrusion 310 gradually decreases, and the width of the support protrusion 310 gradually stabilizes. Referring to (b) of FIG. 13, from the protrusion vertex of the support protrusion 310 to the root of the support protrusion 310, the width of the support protrusion 310 gradually increases, and the rate of width increase of the support protrusion 310 gradually increases, and the root of the support protrusion 310 is its widest position. Referring to (c) of FIG. 13, from the protrusion vertex of the support protrusion 310 to the root of the support protrusion 310, the support protrusion 310 may include a transition segment 311 and a straight rod segment 312 connected sequentially, the width of the transition segment 311 gradually increases, and the width of the straight rod segment 312 remains unchanged.

Referring to FIG. 14, as another example, the outer wall surface of the support protrusion 310 may also be provided with a variable-diameter portion. From the protrusion vertex of the support protrusion 310 to the root of the support protrusion 310, the support protrusion 310 may include a head 313 and a rod portion 314. The protrusion vertex is formed at the top end of the head 313, and a connecting portion between the head 313 and the rod portion 314 is the variable-diameter portion.

For example, referring to (a), (b) and c of FIG. 14, in some examples, the width of the rod portion 314 may remain unchanged. (a) and (b) show a case that the width of the head 313 of the support protrusion 310 from the protrusion vertex to an end connected to the rod portion 314 gradually increases and then gradually decreases, the width at the widest position of the head 313 of the support protrusion 310 is greater than the width of the rod portion 314, and the cross-sectional shape of the head 313 is, for example, a circular arc-shaped surface or an elliptical arc-shaped surface. (c) shows a case that the width of the head 313 of the support protrusion 310 from the protrusion vertex to the end connected to the rod portion 314 gradually increases, the rate of width increase becomes larger and larger, and the width of the head 313 at the end connected to the rod portion 314 reaches its maximum. Referring to (d) of FIG. 14, in some other examples, the width of the head 313 of the support protrusion 310 from the protrusion vertex to the end connected to the rod portion 314 may gradually increase and then decrease, and the width of the rod portion 314 from an end of the rod portion 314 connected to the head 313 to the root of the support protrusion 310 (the end of the rod portion 314 connected to the outer support plate 300) may gradually increase.

FIG. 13 and FIG. 14 show a case that there is a gap between adjacent support protrusions 310. Referring to FIG. 15, in other examples, while ensuring the spacing between the protrusion vertexes of the support protrusions 310, adjacent support protrusions 310 may also overlap with each other. Exemplarily, referring to (a) of FIG. 15, for the case that the outer wall surface of the support protrusion 310 is a smooth wall surface (as shown in FIG. 13), or for the case that the width of the head 313 of the support protrusion 310 from the protrusion vertex to the end connected to the rod portion 314 gradually increases, the rate of width increase becomes larger and larger, and the width of the rod portion 314 of the support protrusion 310 remains unchanged (as shown in (c) of FIG. 14), adjacent support protrusions 310 may overlap with each other. For the case that the width of the head 313 of the support protrusion 310 from the protrusion vertex to the end connected to the rod portion 314 gradually increases and then gradually decreases, and the width of the rod portion 314 from the end of the rod portion 314 connected to the head 313 to the root of the support protrusion 310 gradually increases (as shown in (d) of FIG. 14), adjacent support protrusions 310 may also overlap with each other.

In addition, for the multiple support protrusions 310 on the outer support plate 300, all support protrusions 310 may maintain a basically consistent outer contour, or the outer contours of different support protrusions 310 may be different, which is not limited in this embodiment.

FIG. 16 is a partial schematic structural diagram of a rotating shaft mechanism in an unfolded state according to an embodiment of this application; FIG. 17 is a partial schematic structural diagram of a rotating shaft mechanism in a folded state according to an embodiment of this application. Referring to FIG. 16 and FIG. 17, in this embodiment, by arranging the support protrusions 310 on the side of the outer support plate 300 close to the inner support plate 200, using the support protrusions 310 to support the flexible circuit board 30 instead of the original method of controlling the bending of the first bending segment 31 of the flexible circuit board 30 through the inner support plate 200, the redundant space of the first bending segment 31 is increased, the bending radius of the first bending segment 31 is increased, and the length of the first bending segment 31 is longer.

Therefore, the overall length of the second bending segment 32 and the third bending segment 33 is reduced, so that the transition between the first bending segment 31 and the second bending segment 32 and between the second bending segment 32 and the third bending segment 33 is gentler. Therefore, the bending radius of the second bending segment 32 and the third bending segment 33 can be correspondingly increased, avoiding the small-angle bending of the flexible circuit board 30, and improving the service life and reliability of the flexible circuit board 30. Moreover, it can prevent the layering of the flexible circuit board 30, avoid abnormal noise during the movement of the flexible circuit board 30, and ensure the user performance of the foldable electronic device 1.

With continued reference to FIG. 16, in order to enable the support protrusions 310 on the outer support plate 300 to control the bent state of the flexible circuit board 30, in this embodiment, the heights of the support protrusions 310 on the outer support plate 300 gradually increase along the direction away from the inner support plate 200, so that while supporting the flexible circuit board 30 through the support protrusions 310, the support protrusions 310 also have a guiding effect on the flexible circuit board 30. Referring to FIG. 17, the support protrusions 310 with the heights gradually increasing can allow the flexible circuit board 30 to bend towards the direction of the decorative plate 400, making the flexible circuit board 30 transition from the first bending segment 31 to the second bending segment 32.

Referring to FIG. 16, for ease of description, this embodiment defines a reference plane a on the outer support plate 300. The reference plane a is a plane where a straight segment of the side surface of the outer support plate 300 facing away from the foldable screen 20 (the side surface facing the decorative plate 400) is located. When the rotating shaft mechanism 13 is in the folded state, the straight segment of the outer support plate 300 may be perpendicular to the width direction of the main shaft 100, that is, the straight segment of the outer support plate 300 is perpendicular to the width direction of the rotating shaft mechanism 13. Using the straight segment of the outer support plate 300 as a reference position for the height of the support protrusion 310 can facilitate the precise setting of the height of each support protrusion 310.

For example, the height of the proximal protrusion 310a on the outer support plate 300 is a distance between the protrusion vertex T1 of the proximal protrusion 310a and the reference plane a, and analogically the height of the n^{th} support protrusion 310 on the outer support plate 300 is a distance between the protrusion vertex Tn of the support protrusion 310 and the reference plane a, where a is an integer greater than or equal to 2.

In order to accurately control the bending radius of the first bending segment 31 of the flexible circuit board 30 through each support protrusion 310 on the outer support plate 300, referring to FIG. 17, the protrusion vertexes of all support protrusions 310 on the outer support plate 300 and a support point Q on the inner wall surface of the inner support plate 200 (the side surface of the inner support plate 200 facing away from the foldable screen 20) for supporting the flexible screen may all be located on a preset circular arc-shaped surface. That is, the protrusion vertexes of all support protrusions 310 on the outer support plate 300 and the support point Q on the inner wall surface of the inner support plate 200 are all located on the same circular arc. For example, the protrusion vertexes of all support protrusions 310 on the outer support plate 300 and the support point Q are located on the same circular arc.

Exemplarily, the inner wall surface of the inner support plate 200 may be provided with a groove (not shown). This groove is configured to support the flexible circuit board 30. The support point Q on the inner support plate 200 may be located within the groove. For example, the support point Q may be a tangent point between the first bending segment 31 of the flexible circuit board 30 and the groove.

In order to avoid the small-angle bending of the flexible circuit board 30, the bending radius of the first bending segment 31 of the flexible circuit board 30 may be pre-designed, so that the bending radius of the first bending segment 31 is within an appropriate range. The preset circular arc-shaped surface is a pre-designed arc with an appropriate bending radius.

In practical application, when the bending radius of the flexible circuit board 30 is less than 0.5 mm, it can be considered that small-angle bending occurs in the flexible circuit board 30. In regard to this, in this embodiment, the bending radius r of the first bending segment 31 of the flexible circuit board 30 may be controlled to be greater than 0.5 mm. In other words, a difference between the radius R of the preset circular arc-shaped surface and the thickness of the flexible circuit board 30 should be greater than 0.5 mm. For example, the bending radius r of the first bending segment 31 of the flexible circuit board 30 may be 0.6 mm, 0.7 mm, 0.8 mm, 0.9 mm, 1 mm, etc. Correspondingly, a difference between the radius R of the preset circular arc-shaped surface and the thickness of the flexible circuit board 30 may be 0.6 mm, 0.7 mm, 0.8 mm, 0.9 mm, 1 mm, etc.

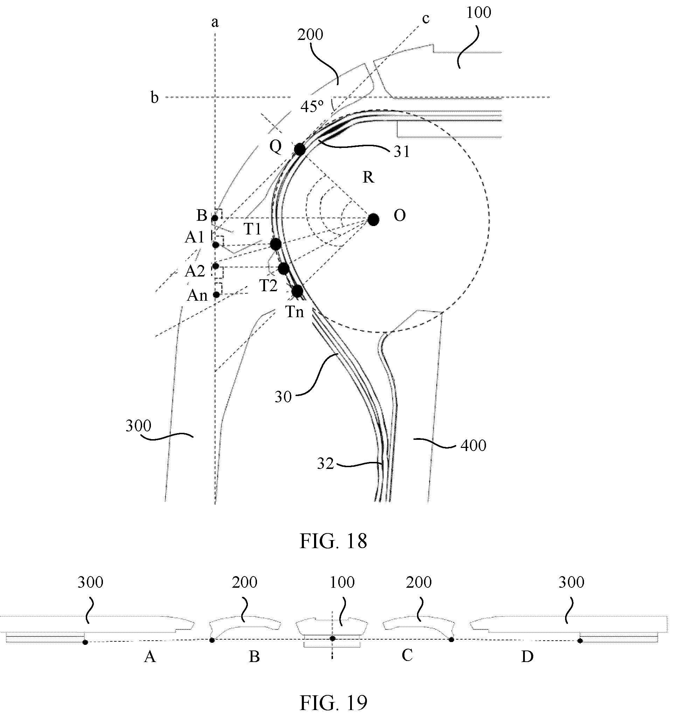

FIG. 18 is a schematic diagram of the design of support protrusions on an outer support plate according to an embodiment of this application. Referring to FIG. 18, in this embodiment, the radius R of the preset circular arc-shaped surface may be designed according to the bending radius required for the first bending segment 31 of the flexible circuit board 30, a central angle corresponding to the circular arc between the protrusion vertex of each support protrusion 310 and the support point Q may be designed by using a connecting line OQ between the center O of the preset circular arc-shaped surface and the support point Q on the inner support plate 200 as a reference, and then the position and height of each support protrusion 310 on the outer support plate 300 may be determined.

For ease of description, in this embodiment, the central angle ∠ QOT1 corresponding to the circular arc between the protrusion vertex T1 of the proximal protrusion 310a on the outer support plate 300 and the support point Q is defined as a first central angle. Taking the protrusion vertex of the distal protrusion 310b on the support plate being Tn (n is a positive integer greater than or equal to 3) as an example, the central angle ∠ QOTn corresponding to the circular arc between the protrusion vertex Tn of the distal protrusion 310b and the support point Q is defined as a second central angle.

Exemplarily, when designing each support protrusion 310 on the outer support plate 300, the first central angle ∠ QOT1 may be greater than or equal to 45° and less than or equal to 65°, so that an appropriate distance can be maintained between the protrusion vertex T1 of the proximal protrusion 310a and the support point Q on the inner support plate 200. As the closest support portion of the first bending segment 31 of the flexible circuit board 30 after the support point Q, it can ensure the support stability of the flexible circuit board 30, also facilitate the adjustment of the bending radius of the first bending segment 31, and facilitate the design of each support protrusion 310 after it.

The second central angle ∠ QOTn is greater than or equal to 80° and less than or equal to 100°. In this way, the length of the circular arc between the protrusion vertex Tn of the distal protrusion 310b and the protrusion vertex T1 of the proximal protrusion 310a is appropriate, facilitating the arrangement of the intermediate protrusion 310c between the two and the combination with the support protrusions 310 according to the redundant length of the flexible circuit board 30. Moreover, the second central angle is constrained to prevent the protrusion vertex Tn of the distal protrusion 310b from being too far away from the protrusion vertex T1 of the proximal protrusion 310a, avoiding the restriction caused by the distal protrusion 310b to the bending trend of the flexible circuit board 30 towards the decorative plate 400, and ensuring that each support protrusion 310 can accurately control the bending radius of the first bending segment 31 of the flexible circuit board 30.

Exemplarily, the first central angle ∠ QOT1 may be 60°, the second central angle ∠ QOTn may be 90°, and the central angle corresponding to the circular arc between the protrusion vertex of the intermediate protrusion 310c and the support point Q may be greater than 60° and less than 90°. Taking one intermediate protrusion 310c being provided between the proximal protrusion 310a and the distal protrusion 310b as an example, the central angle corresponding to the circular arc between the protrusion vertex T2 of the intermediate protrusion 310c and the support point Q on the inner support plate 200 is a third central angle, and the third central angle ∠ QOT2 may be greater than 65° and less than 80°. For example, the third central angle ∠ QOT2 is 75°.

Determining the central angle corresponding the circular arc between the protrusion vertex of each support protrusion 310 on the outer support plate 300 and the support point Q on the inner support plate 200 is equivalent to determining the position of the protrusion vertex of each support protrusion 310, and correspondingly the height of each support protrusion 310 can be calculated.

With continued reference to FIG. 18, during designing, a horizontal plane b that is tangent to both the flexible circuit board 30 and the inner wall surface of the main shaft 100 (the side wall surface of the main shaft 100 facing away from the foldable screen 20) is first determined, a tangent plane c that is tangent to both the flexible circuit board 30 and the inner support plate 200 is determined, and the position and height of each support protrusion 310 are determined in combination with the reference plane a of the outer support plate 300.

First, the position of the center O is determined according to the radius R of the preset circular arc-shaped surface. A perpendicular line is drawn along the support point Q on the inner support plate 200, so that QO is perpendicular to the tangent plane c, and QO is equal to R and equal to the bending radius r of the first bending segment 31 plus the thickness of the flexible circuit board 30, determining the position of the center O of the preset circular arc-shaped surface correspondingly.

Taking the determination of the position and height of the proximal protrusion 310a as an example, the first central angle ∠ QOT1 corresponding to the protrusion vertex T1 of the proximal protrusion 310a is made on a preset circular arc-shaped surface with a center of O and a radius of R, so as to determine the position of the protrusion vertex T1 of the proximal protrusion 310a. OB perpendicular to the reference plane a is made, point B is on the reference plane a, and the length of BO is determined according to the structural dimension of the rotating shaft mechanism 13 in the folded state. T1A1 perpendicular to the reference plane a is made, A1 is on the reference plane a, and the height A1T1 of the proximal protrusion 310a can be calculated according to the Pythagorean theorem. A1T1=[BO/sin(180°- ∠ BOQ- ∠ QOT1)-R]sin(180°- ∠ BOQ- ∠ QOT1)=BO-R sin(180°-∠ BOQ- ∠ QOT1).

Analogically, on the preset circular arc-shaped surface with the center of O and the radius of R, the central angles corresponding to the protrusion vertexes of other support protrusions 310 are made. Taking the support protrusion 310 with a protrusion vertex Tn in the figure as an example, the central angle ∠ QOTn corresponding to the protrusion vertex Tn of the support protrusion 310 is made, and the position of the protrusion vertex Tn of the support protrusion 310 is determined. TnAn perpendicular to the reference plane a is made, An is on the reference plane a, and the height AnTn of the support protrusion 310 can be calculated according to the Pythagorean theorem. AnTn=[BO/sin(180°- ∠ BOQ- L QOTn)-R]sin(180°- ∠ BOQ- L QOTn)=BO-R sin(180°- ∠ BOQ- ∠ QOTn).

With continued reference to FIG. 18, taking the included angle of 45° between the horizontal plane b and the tangent plane c as an example, and taking the central angle of 45° corresponding to the circular arc on the preset circular arc-shaped surface and the support point Q as the reference central angle, by appropriately increasing the angle by a specified increment, the first central angle ∠ QOT1 corresponding to the protrusion vertex T1 of the proximal protrusion 310a, the central angle ∠ QOT2 corresponding to the protrusion vertex T2 of the support protrusion 310 adjacent to the proximal protrusion 310a, and the central angle ∠ QOTn corresponding to the protrusion vertex Tn (n is a positive integer greater than or equal to 3) of each subsequent support protrusion 310 are determined, and then the height of each support protrusion 310, such as A1T1, A2T2... AnTn, is determined.

Specifically, taking three support protrusions 310 being provided on the outer support plate 300 as an example, where the three support protrusions 310 are respectively a proximal protrusion 310a (protrusion vertex T1), an intermediate protrusion 310c (protrusion vertex T2), and a distal protrusion 310b (protrusion vertex Tn, n=3), and taking ∠ QOT1=60°, *L* QOT2=75°, and *L* QOTn=90° as an example, then: A1T1= BO-R sin(180°-∠ BOQ-∠ QOT1)= BO-R sin(180°-45°-60°)= BO-R sin75°, A2T2= BO-R sin(180°- ∠ BOQ- ∠ QOT2)= BO-R sin(180°-45°-75°)= BO-R sin60°, AnTn= BO-R sin(180°- ∠ BOQ- *L* QOTn)= BO-R sin(180°-45°-90°)= BO-R sin45°.

As for how to meet the requirements of flexible circuit boards 30 with different redundant lengths through different combinations of support protrusions 310 on the outer support plate 300, in some implementations, the support protrusions 310 on the outer support plate 300 for supporting the flexible circuit board 30 may be determined according to a redundancy factor of the flexible circuit board 30. Regardless of the redundant length of the flexible circuit board 30, among the support protrusions 310 on the outer support plate 300, the proximal protrusion 310a can always be in contact with the flexible circuit board 30. Depending on the redundant length of the flexible circuit board 30, the intermediate protrusion 310c and the distal protrusion 310b can have different combinations.

This embodiment defines the redundancy factor of the flexible circuit board 30 being a percentage of the redundant length of the flexible circuit board 30 to the required reference length. In other words, the redundancy factor of the flexible circuit board 30 is 100*(actual length-reference length)/reference length. The length of the flexible circuit board 30 is determined based on its bending segment. The bending segment is a segment of the flexible circuit board 30 that is fixedly connected between the outer support plates 300 on the two sides and will deform with the movement of the rotating shaft mechanism 13.

The reference length of the flexible circuit board 30 may be considered as the length when the rotating shaft mechanism 13 is in the unfolded state and in the taut state. That is, the reference length of the flexible circuit board 30 exactly meets the requirement and has no redundancy. FIG. 19 is a schematic diagram of a design of reference length of a flexible circuit board according to an embodiment of this application. Referring to FIG. 19, the reference length of the flexible circuit board 30 may be determined according to the size of the rotating shaft mechanism 13 in the unfolded state. Taking the bending segment of the flexible circuit board 30 being in an unbent state when the rotating shaft mechanism 13 is in the unfolded state as an example, the reference length of the flexible circuit board 30 may be the sum of the lengths of segments A, B, C, and D shown in the figure. That is, the reference length of the flexible circuit board 30 is equal to A+B+C+D.

The actual length of the flexible circuit board 30, as the name suggests, is an actual length of the bending segment of the flexible circuit board 30 located between the outer support plates 300 on the two sides. For the flexible circuit board 30 with a redundant length, the actual length of the flexible circuit board 30 is greater than the required reference length, and the redundant length of the flexible circuit board 30 is a difference between its actual length and the reference length.

In a case that the redundancy factor of the flexible circuit board 30 is within a first preset range, only the proximal protrusion 310a may be in contact with the flexible circuit board 30; in a case that the redundancy factor of the flexible circuit board 30 is within a second preset range, the proximal protrusion 310a and at least some of the intermediate protrusions 310c may be in contact with the flexible circuit board 30; in a case that the redundancy factor of the flexible circuit board 30 is within a third preset range, the proximal protrusion 310a and the distal protrusion 310b may be in contact with the flexible circuit board 30. The maximum value of the first preset range is less than the minimum value of the second preset range, and the maximum value of the second preset range is less than the minimum value of the third preset range.

Exemplarily, the first preset range of the redundancy factor of the flexible circuit board 30 may be between 0 and 1. That is to say, in a case that the redundancy factor is greater than 0 and less than or equal to 1, it indicates that the redundant length of the flexible circuit board 30 is very small. At this time, the bending radius of the first bending segment 31 of the flexible circuit board 30 may be controlled to be small, and the first bending segment 31 of the flexible circuit board 30 may be in contact with the proximal protrusion 310a only. In other words, the flexible circuit board 30 is supported through the proximal protrusion 310a only.

The second preset range of the redundancy factor of the flexible circuit board 30 may be between 1 and 2. That is to say, in a case that the redundancy factor is greater than 1 and less than or equal to 2, it indicates that the redundant length of the flexible circuit board 30 is moderate. At this time, the first bending radius of the flexible circuit board 30 may be controlled to be slightly large, and the first bending segment 31 of the flexible circuit board 30 may be in contact with the proximal protrusion 310a and at least some of the intermediate protrusions 310c. In other words, the flexible circuit board 30 is supported through the proximal protrusion 310a and at least part of the intermediate protrusion 310c. Taking only one intermediate protrusion 310c being provided on the outer support plate 300 as an example, the flexible circuit board 30 can be supported on the proximal protrusion 310a and the intermediate protrusion 310c.

The third preset range of the redundancy factor of the flexible circuit board 30 may be greater than 2. That is to say, when the redundancy factor is greater than 2, it indicates that the redundant length of the flexible circuit board 30 is large. At this time, the first bending radius of the flexible circuit board 30 may be controlled to be further large, and the first bending segment 31 of the flexible circuit board 30 may be in contact with the proximal protrusion 310a and the distal protrusion 310b. In other words, the flexible circuit board 30 is supported through the proximal protrusion 310a and the distal protrusion 310b.

It should be stated that when the flexible circuit board 30 is supported on the proximal protrusion 310a and the distal protrusion 310b, the situation that the intermediate protrusion 310c supports the flexible circuit board 30 may be controlled according to the redundancy factor of the flexible circuit board 30. For example, in a case that the redundancy factor of the flexible circuit board 30 is between 2 and 2.5, all support protrusions 310 on the outer support plate 300 may be configured to support the flexible circuit board 30. That is, the flexible circuit board 30 is supported jointly through the proximal protrusion 310a, the intermediate protrusion 310c, and the distal protrusion 310b. In a case that the redundancy factor of the flexible circuit board 30 is greater than 2.5, the bending radius of the first bending segment 31 of the flexible circuit board 30 may be controlled to be larger. At this time, the first bending segment 31 of the flexible circuit board 30 is supported only through the proximal protrusion 310a and the distal protrusion 310b.

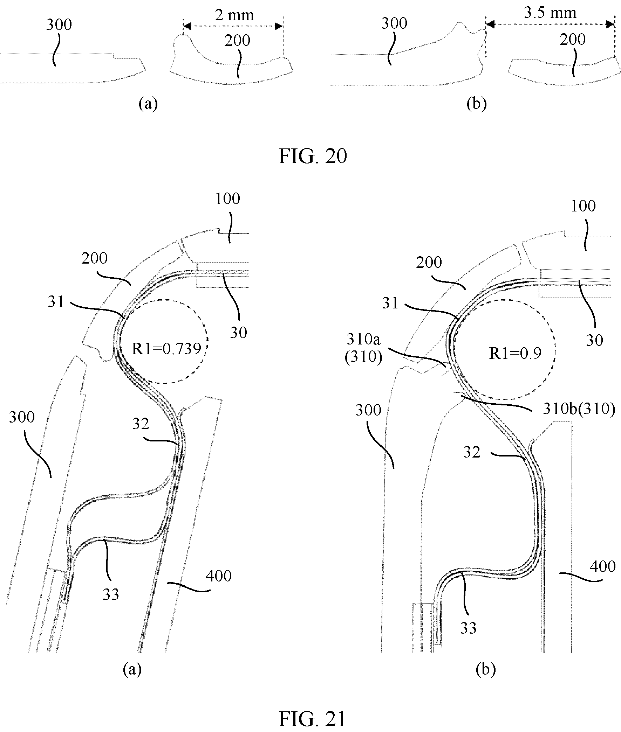

FIG. 20 is a partial schematic structural diagram of a rotating shaft mechanism applied in a simulated comparative example according to an embodiment of this application; FIG. 21 is a comparison result of simulation applying the rotating shaft mechanism in FIG. 20.

Referring to (a) of FIG. 20, the original scheme adopts an inner support plate 200 to control the bending radius of the first bending segment 31 of the flexible circuit board 30, and the redundant space of the first bending segment 31 in the width direction of the rotating shaft mechanism 13 is 2 mm. Referring to (b) of FIG. 20, this embodiment adopts an outer support plate 300 to control the bending radius of the first bending segment 31 of the flexible circuit board 30, and the redundant space of the first bending segment 31 in the width direction of the rotating shaft mechanism 13 is 3.5 mm. Therefore, compared with the original method of controlling the first bending segment 31 of the flexible circuit board 30 through the inner support plate 200, this embodiment controls the first bending segment 31 of the flexible circuit board 30 by the outer support plate 300, significantly increasing the redundant space of the first bending segment 31.

Specifically, the simulated comparative example takes the reference length of the flexible circuit board 30 being 17 mm, the redundant length of the flexible circuit board 30 being 0.5 mm, and the corresponding redundancy factor being 2.9 as an example. In this embodiment, the proximal protrusion 310a and the distal protrusion 310b on the outer support plate 300 are selected to control the bending radius of the first bending segment 31 of the flexible circuit board 30. The radius R of the preset circular arc-shaped surface where the protrusion vertex of each support protrusion 310 is located is equal to the bending radius of the first bending segment 31 plus the thickness of the flexible circuit board 30, that is, 0.9 mm+0.127 mm=1.027 mm. Through the calculation formula of the position and height of the support protrusion 310, it is determined that the first central angle ∠ QOT1 corresponding to the proximal protrusion 310a is 60°, the second central angle ∠ QOTn corresponding to the distal protrusion 310b is 90°, and a structural diagram of the support protrusion 310 on the outer support plate 300 is made.

**Table 1 Comparison between simulation results of bending radius and stress of first bending segment of flexible circuit board before and after optimization**

| Scheme | Whether the flexible circuit board is layered | Bending radius r (mm) | Pushing force of inner support plate (N) |
|---|---|---|---|
| Original scheme | Yes | 0.739 | 1.53 |
| This embodiment | No | 0.900 | 0.75 |
| Improvement percentage | / | 22% | 51% |

Referring to (a) of FIG. 21 and Table 1, in the original scheme, when the flexible circuit board 30 is in the bent state, the bending radius of the first bending segment 31 of the flexible circuit board 30 is 0.739 mm, the flexible circuit board 30 is layered, and the pushing force of the inner support plate 200 to the flexible circuit board 30 (the pressure of the flexible circuit board 30 to the inner support plate 200) is 1.53 N. Referring to (b) of FIG. 21 and Table 1, in the scheme in this embodiment, when the flexible circuit board 30 is in the bent state, the bending radius of the first bending segment 31 of the flexible circuit board 30 is 0.9 mm, the flexible circuit board 30 is not layered, and the pushing force of the inner support plate 200 to the flexible circuit board 30 is 0.75 N.

Hence, it can be seen that the scheme in this embodiment adopts the outer support plate 300 to control the first bending segment 31, so that the redundant space of the first bending segment 31 is significantly increased. Compared with the original scheme, this embodiment increases the bending radius of the first bending segment 31 of the flexible circuit board 30 by 22%, and alleviates the pushing force of the inner support plate 200 by 51%. The scheme in this embodiment can make the overall bending of the flexible circuit board 30 more gentle, solve the problem of layering of the flexible circuit board 30, reduce the contact area between the flexible circuit board 30 and the support plate assembly, reduce the pushing force of the flexible circuit board 30 to the inner support plate 200, and eliminate the abnormal noise during the movement of the flexible circuit board 30.

In the description of the embodiments of this application, it should be stated that unless otherwise specified and limited, the terms "mount", "connect", and "connection" should be broadly understood. For example, it may be fixed connection, indirect connection through an intermediate medium, internal communication of two components, or interaction between two components. Those skilled in the art may understand the specific meanings of the foregoing terms in the embodiments of this application based on the specific situations.

The terms such as "first", "second", "third", and "fourth" (if exist) in the description and claims of this application are used for distinguishing similar objects, instead of describing a specific order or sequence.

## Claims

1. A rotating shaft mechanism applied to a foldable electronic device and having an unfolded state and a folded state, comprising:
a main shaft;
inner support plates, movably connected to two sides of a width direction of the main shaft; and
outer support plates, located on the two sides of the width direction of the main shaft and movably connected to a side of each inner support plate facing away from the main shaft, wherein
a side surface of each outer support plate facing away from a foldable screen of the foldable electronic device is provided with a plurality of support protrusions, the plurality of support protrusions are located on a side of each outer support plate close to the inner support plate, all support protrusions are sequentially arranged along a width direction of each outer support plate, and at least some of the support protrusions are configured to support a flexible circuit board passing through the rotating shaft mechanism.

2. The rotating shaft mechanism according to claim 1, wherein an end of each support protrusion away from the outer support plate is provided with a protrusion vertex, and the protrusion vertex is configured to support the flexible circuit board.

3. The rotating shaft mechanism according to claim 2, wherein an end surface of each support protrusion away from the outer support plate is an arc-shaped surface, and the protrusion vertex is a vertex of the arc-shaped surface.

4. The rotating shaft mechanism according to claim 3, wherein the heights of the support protrusions gradually increase along a direction away from the inner support plate, wherein the height of each support protrusion is a distance from the protrusion vertex to a reference plane of the outer support plate, the reference plane is a plane where a straight segment of the side surface of the outer support plate facing away from the foldable screen is located, and the straight segment is perpendicular to the width direction of the main shaft when the rotating shaft mechanism is in the folded state.

5. The rotating shaft mechanism according to claim 4, wherein the protrusion vertex of each support protrusion and a support point on an inner wall surface of each inner support plate for supporting the flexible circuit board are located on a preset circular arc-shaped surface, wherein the inner wall surface of the inner support plate is a side surface of the inner support plate facing away from the foldable screen.

6. The rotating shaft mechanism according to claim 5, wherein a difference between the radius of the preset circular arc-shaped surface and the thickness of the flexible circuit board is greater than 0.5 mm.

7. The rotating shaft mechanism according to claim 5, wherein among the support protrusions, the support protrusion closest to the inner support plate is a proximal protrusion, the support protrusion farthest from the inner support plate is a distal protrusion, and at least one intermediate protrusion is provided between the proximal protrusion and the distal protrusion,
wherein on the preset circular arc-shaped surface, a central angle corresponding to an arc between the proximal protrusion and the support point is a first central angle, and the first central angle is greater than or equal to 45° and less than or equal to 65°; a central angle corresponding to an arc between the distal protrusion and the support point is a second central angle, and the second central angle is greater than or equal to 80° and less than or equal to 100°.

8. The rotating shaft mechanism according to claim 7, wherein the first central angle is 60°, and the second central angle is 90°.

9. The rotating shaft mechanism according to claim 7, wherein one intermediate protrusion is provided between the proximal protrusion and the distal protrusion, a central angle corresponding to an arc between the intermediate protrusion and the support point is a third central angle, and the third central angle is greater than 65° and less than 80°.

10. The rotating shaft mechanism according to claim 9, wherein the third central angle is 75°.

11. The rotating shaft mechanism according to any one of claims 7 to 10, wherein in a case that a redundancy factor of the flexible circuit board is within a first preset range, the proximal protrusion is in contact with the flexible circuit board;
in a case that the redundancy factor of the flexible circuit board is within a second preset range, the proximal protrusion and at least some of the intermediate protrusions are in contact with the flexible circuit board;
in a case that the redundancy factor of the flexible circuit board is within a third preset range, the proximal protrusion and the distal protrusion are in contact with the flexible circuit board,
wherein the maximum value of the first preset range is less than the minimum value of the second preset range, the maximum value of the second preset range is less than the minimum value of the third preset range, and the redundancy factor of the flexible circuit board is a percentage of the redundant length of the flexible circuit board to the reference length of the flexible circuit board.

12. The rotating shaft mechanism according to claim 11, wherein the first preset range is greater than 0 and less than or equal to 1, the second preset range is greater than 1 and less than or equal to 2, and the third preset range is greater than 2.

13. The rotating shaft mechanism according to any one of claims 3 to 12, wherein an outer wall surface of the support protrusion is a smooth wall surface that extends smoothly from the protrusion vertex to a surface of the outer support plate.

14. The rotating shaft mechanism according to claim 13, wherein the width of the support protrusion gradually increases from the protrusion vertex to an end of the support protrusion connected to the outer support plate;
or, the support protrusion comprises a transition segment and a straight rod segment connected sequentially from the protrusion vertex to the end of the support protrusion connected to the outer support plate, the width of the transition segment gradually increases, and the width of the straight rod segment remains unchanged.

15. The rotating shaft mechanism according to any one of claims 3 to 12, wherein the support protrusion comprises a head and a rod portion from the protrusion vertex to an end of the support protrusion connected to the outer support plate, and a connecting portion between the head and the rod portion is a variable-diameter portion.

16. The rotating shaft mechanism according to claim 15, wherein the width of the rod portion remains unchanged or gradually increases from an end of the rod portion connected to the head to the end of the rod portion connected to the outer support plate.

17. The rotating shaft mechanism according to any one of claims 13 to 16, wherein a gap exists between adjacent support protrusions, or adjacent support protrusions overlap with each other.

18. The rotating shaft mechanism according to any one of claims 1 to 17, further comprising:
decorative plates, movably connected to the two sides of the width direction of the main shaft and arranged opposite to the inner support plates on the two sides of the thickness direction of the main shaft, wherein the decorative plates, the inner support plates and the outer support plates enclose to form a space for accommodating the flexible circuit board.

19. The rotating shaft mechanism according to any one of claims 1 to 18, further comprising:
a fixing assembly, mounted to the main shaft and configured to fix the flexible circuit board.

20. The rotating shaft mechanism according to claim 19, wherein the fixing assembly comprises a first magnetic member and a second magnetic member arranged opposite to each other, and the first magnetic member and the second magnetic member are configured to clamp the flexible circuit board.

21. A foldable electronic device, comprising a first housing, a second housing, and the rotating shaft mechanism according to any one of claims 1 to 20, wherein the first housing and the second housing are respectively connected to two sides of the rotating shaft mechanism.

22. The foldable electronic device according to claim 21, further comprising a foldable screen, wherein the foldable screen is mounted on the first housing and the second housing, and the foldable screen is supported onto the rotating shaft mechanism;
when the foldable electronic device is in the folded state, the first housing and the second housing are stacked relative to each other, and the foldable screen wraps around the first housing and the second housing.
